# EUROPEAN PATENT APPLICATION

(11) **EP 2 680 329 A2**
(43) Date of publication of application: **01.01.2014**
(21) Application number: 13174269.4
(22) Date of filing: 28.06.2013
(51) Int. Cl.: H01L 33/50

(54) **Phosphor layer-covered LED, producing method thereof, and LED device**

(30) Priority: 29.06.2012 JP 2012147551; 30.01.2013 JP 2013015784
(71) Applicant: NITTO DENKO CORPORATION, Ibaraki-shi, Osaka 567-8680 (JP)
(72) Inventor: Kimura, Ryuichi, Osaka, 567-8680 (JP); Katayama, Hiroyuki, Osaka, 567-8680 (JP); Ebe, Yuki, Osaka, 567-8680 (JP); Onishi, Hidenori, Osaka, 567-8680 (JP); Fuke, Kazuhiro, Osaka, 567-8680 (JP)
(74) Representative: HOFFMANN EITLE

(57) **Abstract**

A method for producing a phosphor layer-covered LED (10) includes an LED disposing step of disposing an LED (4) at one surface in a thickness direction of a support sheet (12); a layer disposing step of disposing a phosphor layer (5) formed from a phosphor resin composition containing an active energy ray curable resin capable of being cured by application of an active energy ray and a phosphor at the one surface in the thickness direction of the support sheet (12) so as to cover the LED (4); a curing step of applying an active energy ray to the phosphor layer (5) to be cured; a cutting step of cutting the phosphor layer (5) corresponding to the LED (4) to produce a phosphor layer-covered LED (10) including the LED and the phosphor layer covering the LED; and an LED peeling step of, after the cutting step, peeling the phosphor layer-covered LED (10) from the support sheet (12).

## Description

### BACKGROUND OF THE INVENTION

### Field of the Invention

The present invention relates to a phosphor layer-covered LED, a producing method thereof, and an LED device, to be specific, to a method for producing a phosphor layer-covered LED, a phosphor layer-covered LED obtained by the method, and an LED device including the phosphor layer-covered LED.

### Description of Related Art

It has been known that, conventionally, a light emitting diode device (hereinafter, abbreviated as an LED device) is produced as follows: first, a plurality of light emitting diode elements (hereinafter, abbreviated as LEDs) are mounted on a board; next, a phosphor layer is provided so as to cover a plurality of the LEDs; and thereafter, the resulting products are singulated into individual LEDs.

Unevenness in emission wavelength and luminous efficiency is generated between a plurality of the LEDs, however, so that in such an LED device mounted with the LED, there is a disadvantage that unevenness in light emission is generated between a plurality of the LEDs.

In order to solve such a disadvantage, it has been considered that, for example, a plurality of LEDs are covered with a phosphor layer to fabricate a plurality of phosphor layer-covered LEDs and thereafter, the phosphor layer-covered LED is selected in accordance with the emission wavelength and the luminous efficiency to be then mounted on a board.

For example, an LED obtained by the following method has been proposed (ref: for example, Japanese Unexamined Patent Publication No. 2012-39013). In the method, an LED is disposed on a pressure-sensitive adhesive sheet; next, a ceramic ink in which a phosphor is dispersed and mixed is applied onto the pressure-sensitive adhesive sheet so as to cover the LED to be heated, so that the ceramic ink is temporarily cured; thereafter, the ceramic ink is subjected to dicing corresponding to the LED; and then, the obtained ceramic ink is fully cured by being subjected to heat treatment at a high temperature (at 160°C) to be vitrified so as to produce the LED. The LED is to be then mounted on a board, so that an LED device is obtained.

### SUMMARY OF THE INVENTION

In the method described in Japanese Unexamined Patent Publication No. 2012-39013, in the ceramic ink, the phosphor precipitates after the elapse of time, so that the phosphor is not uniformly dispersed around the LED and thus, there is a disadvantage that the unevenness in the light emission is not capable of being sufficiently solved.

Additionally, in the method described in Japanese Unexamined Patent Publication No. 2012-39013, the ceramic ink applied onto the pressure-sensitive adhesive sheet is fully cured by the heat treatment at a high temperature, so that there is a disadvantage that the pressure-sensitive adhesive sheet is damaged.

It is an object of the present invention to provide a method for producing a phosphor layer-covered LED in which a phosphor is uniformly disposed around an LED and various support sheets are capable of being used, while the damage thereof is prevented, a phosphor layer-covered LED obtained by the method, and an LED device including the phosphor layer-covered LED.

A method for producing a phosphor layer-covered LED of the present invention includes an LED disposing step of disposing an LED at one surface in a thickness direction of a support sheet; a layer disposing step of disposing a phosphor layer formed from a phosphor resin composition containing an active energy ray curable resin capable of being cured by application of an active energy ray and a phosphor at the one surface in the thickness direction of the support sheet so as to cover the LED; a curing step of applying an active energy ray to the phosphor layer to be cured; a cutting step of cutting the phosphor layer corresponding to the LED to produce a phosphor layer-covered LED including the LED and the phosphor layer covering the LED; and an LED peeling step of, after the cutting step, peeling the phosphor layer-covered LED from the support sheet.

In the method for producing a phosphor layer-covered LED of the present invention, it is preferable that the phosphor layer is formed of a phosphor sheet.

In the method for producing a phosphor layer-covered LED of the present invention, it is preferable that the support sheet is capable of stretching in a direction perpendicular to the thickness direction and in the LED peeling step, the phosphor layer-covered LED is peeled from the support sheet, while the support sheet is stretched in the direction perpendicular to the thickness direction.

In the method for producing a phosphor layer-covered LED of the present invention, it is preferable that the support sheet is a thermal release sheet in which the pressure-sensitive adhesive force is capable of being reduced by heating and in the LED peeling step, the support sheet is heated and the phosphor layer-covered LED is peeled from the support sheet.

In the method for producing a phosphor layer-covered LED of the present invention, it is preferable that the phosphor layer includes a cover portion that covers the LED and a reflector portion that contains a light reflecting component and is formed so as to surround the cover portion.

A phosphor layer-covered LED of the present invention is obtained by a method for producing a phosphor layer-covered LED including an LED disposing step of disposing an LED at one surface in a thickness direction of a support sheet; a layer disposing step of disposing a phosphor layer formed from a phosphor resin composition containing an active energy ray curable resin capable of being cured by application of an active energy ray and a phosphor at the one surface in the thickness direction of the support sheet so as to cover the LED; a curing step of applying an active energy ray to the phosphor layer to be cured; a cutting step of cutting the phosphor layer corresponding to the LED to produce a phosphor layer-covered LED including the LED and the phosphor layer covering the LED; and an LED peeling step of, after the cutting step, peeling the phosphor layer-covered LED from the support sheet.

An LED device of the present invention includes a board and a phosphor layer-covered LED mounted on the board, wherein the phosphor layer-covered LED is obtained by a method for producing a phosphor layer-covered LED including an LED disposing step of disposing an LED at one surface in a thickness direction of a support sheet; a layer disposing step of disposing a phosphor layer formed from a phosphor resin composition containing an active energy ray curable resin capable of being cured by application of an active energy ray and a phosphor at the one surface in the thickness direction of the support sheet so as to cover the LED; a curing step of applying an active energy ray to the phosphor layer to be cured; a cutting step of cutting the phosphor layer corresponding to the LED to produce a phosphor layer-covered LED including the LED and the phosphor layer covering the LED; and an LED peeling step of, after the cutting step, peeling the phosphor layer-covered LED from the support sheet.

In the method for producing a phosphor layer-covered LED of the present invention, the phosphor layer that is formed from a phosphor resin composition containing an active energy ray curable resin, which is capable of being cured by application of an active energy ray, and a phosphor is laminated at the one surface in the thickness direction of the support sheet so as to cover the LED. Thereafter, the active energy ray is applied to the phosphor layer and the LED is encapsulated by the phosphor layer. Thus, a damage caused by heating of the support sheet is suppressed and the LED is encapsulated, so that the phosphor is capable of being uniformly dispersed around the LED.

Also, by cutting the phosphor layer corresponding to the LED, the phosphor layer-covered LED including the LED and the phosphor layer covering the LED is obtained. Thereafter, the phosphor layer-covered LED is peeled from the support sheet. Thus, the phosphor layer supported by the support sheet in which a damage is suppressed is cut with excellent size stability, so that the phosphor layer-covered LED having excellent size stability can be obtained.

Consequently, the phosphor layer-covered LED of the present invention has excellent size stability.

Also, the LED device of the present invention includes the phosphor layer-covered LED having excellent size stability, so that it has excellent reliability and thus, its luminous efficiency is improved.

### BRIEF DESCRIPTION OF THE DRAWINGS

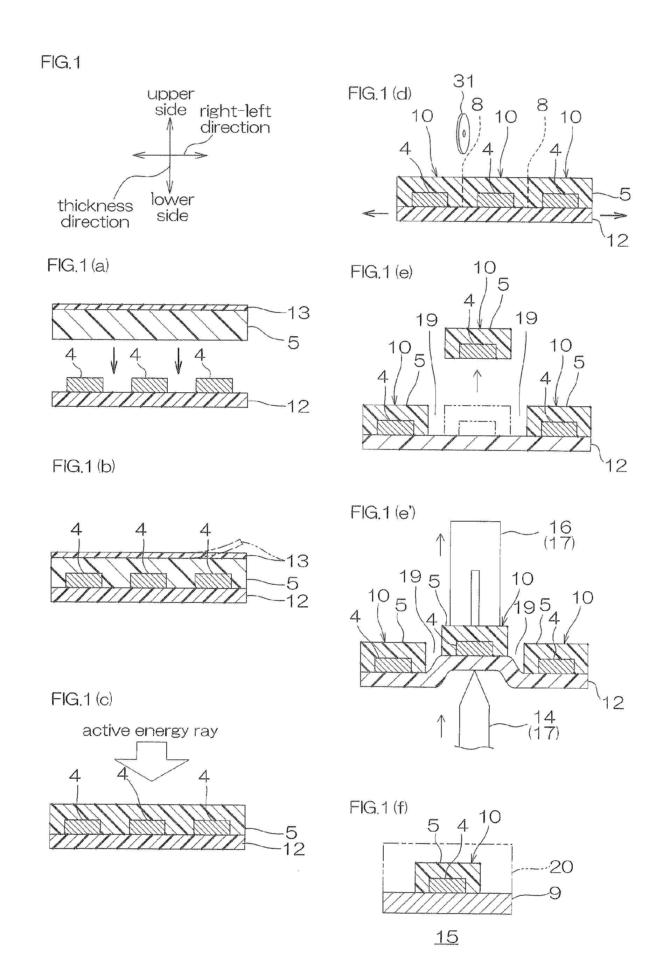

FIG. 1 shows process drawings for illustrating a first embodiment of a method for producing a phosphor layer-covered LED of the present invention:
FIG. 1 (a) illustrating a step of disposing LEDs on the upper surface of a support sheet (an LED disposing step),
FIG. 1 (b) illustrating a step of disposing a phosphor sheet on the support sheet (a sheet disposing step),
FIG. 1 (c) illustrating a step of applying an active energy ray to the phosphor sheet to cure the phosphor sheet and encapsulating the LEDs by the phosphor sheet (an encapsulating step),
FIG. 1 (d) illustrating a step of cutting the phosphor sheet (a cutting step),
FIG. 1 (e) illustrating a step of peeling phosphor layer-covered LEDs from the support sheet (an LED peeling step),
FIG. 1 (e') illustrating a step of describing the details of a state of peeling the phosphor layer-covered LEDs from the support sheet using a pick-up device in the LED peeling step in FIG. 1 (e), and
FIG. 1 (f) illustrating a step of mounting the phosphor layer-covered LED on a board (a mounting step).
FIG. 2 shows process drawings for illustrating a second embodiment of a method for producing a phosphor layer-covered LED of the present invention:
FIG. 2 (a) illustrating a step of disposing LEDs on a support sheet (an LED disposing step),
FIG. 2 (b) illustrating a step of disposing an embedding-reflector sheet on the support sheet (a sheet disposing step),
FIG. 2 (c) illustrating a step of applying an active energy ray to the embedding-reflector sheet to cure embedding portions and encapsulating the LEDs by the embedding portions (an encapsulating step),
FIG. 2 (d) illustrating a step of cutting a reflector portion (a cutting step),
FIG. 2 (e) illustrating a step of peeling phosphor sheet-covered LEDs each including the reflector portion from the support sheet (an LED peeling step),

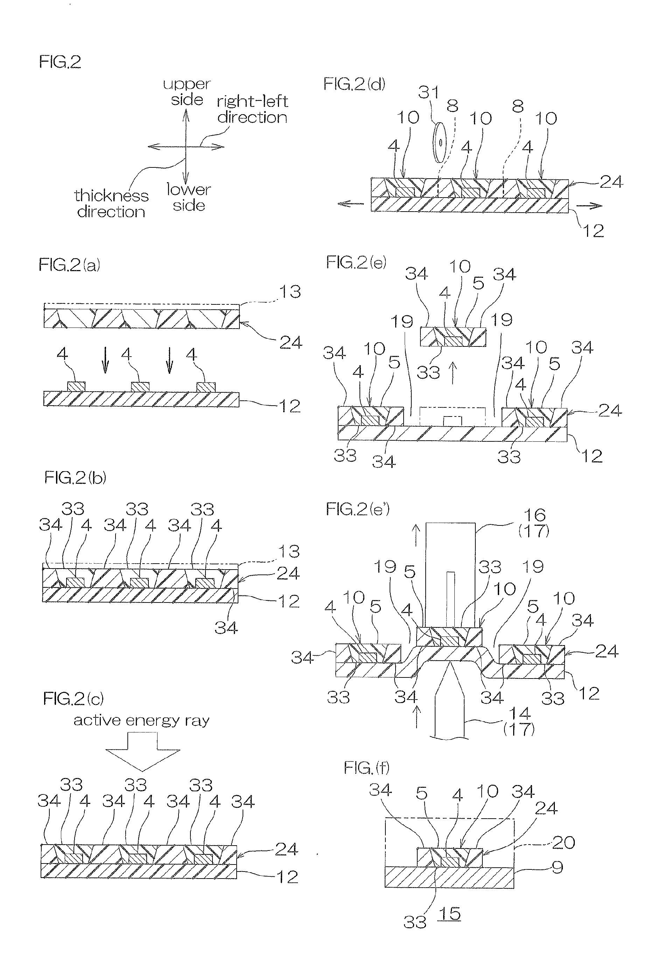

FIG. 2 (e') illustrating a step of describing the details of a state of peeling the phosphor sheet-covered LEDs from the support sheet using a pick-up device in the LED peeling step in FIG. 2 (e), and
FIG. 2 (f) illustrating a step of mounting the phosphor sheet-covered LED including the reflector portion on a board (a mounting step).

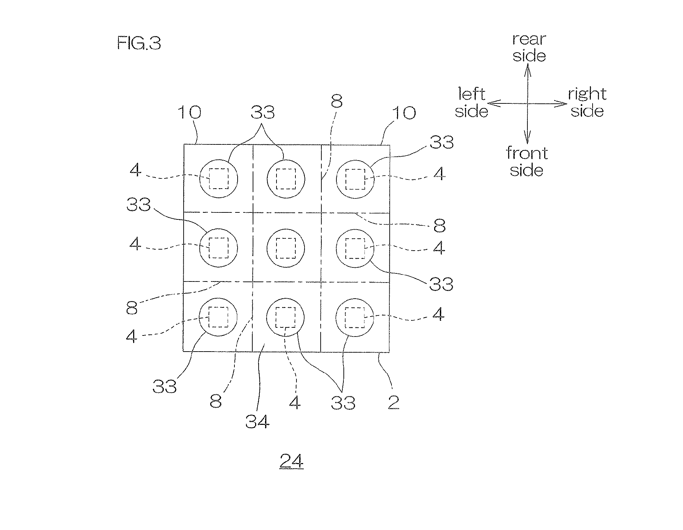

FIG. 3 shows a plan view of the phosphor sheet-embedded LEDs shown in FIG. 2 (d).

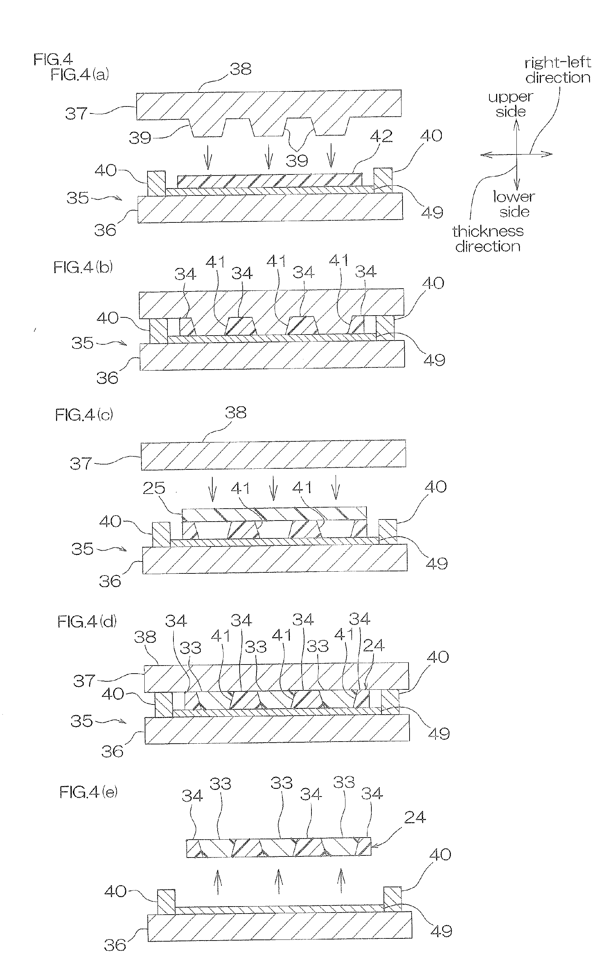

FIG. 4 shows process drawings for illustrating a method for producing the embedding-reflector sheet shown in FIG. 2 (a):
FIG. 4 (a) illustrating a step of disposing a reflector sheet on a pressing device,
FIG. 4 (b) illustrating a step of pressing the reflector sheet to form a reflector portion,
FIG. 4 (c) illustrating a step of disposing a phosphor sheet on the reflector portion,
FIG. 4 (d) illustrating a step of pressing the phosphor sheet to form embedding portions, and
FIG. 4 (e) illustrating a step of peeling the embedding-reflector sheet from a releasing sheet.

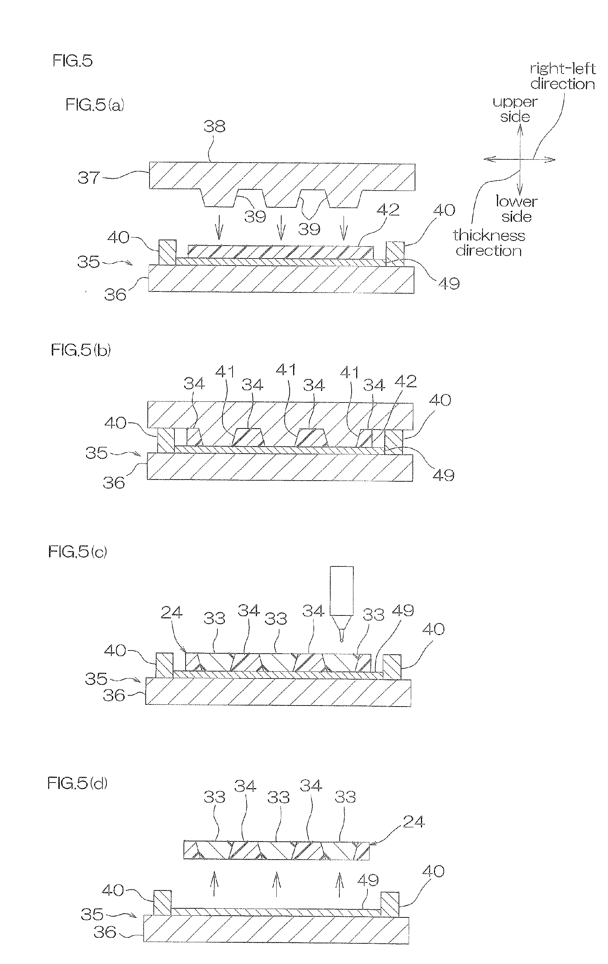

FIG. 5 shows process drawings for illustrating a method for producing an embedding-reflector sheet used in a third embodiment of a method for producing a phosphor layer-covered LED of the present invention:
FIG. 5 (a) illustrating a step of disposing a reflector sheet on a pressing device,
FIG. 5 (b) illustrating a step of pressing the reflector sheet to form a reflector portion,
FIG. 5 (c) illustrating a step of potting a varnish of a phosphor resin composition into through holes, and
FIG. 5 (d) illustrating a step of peeling the embedding-reflector sheet from a releasing sheet.

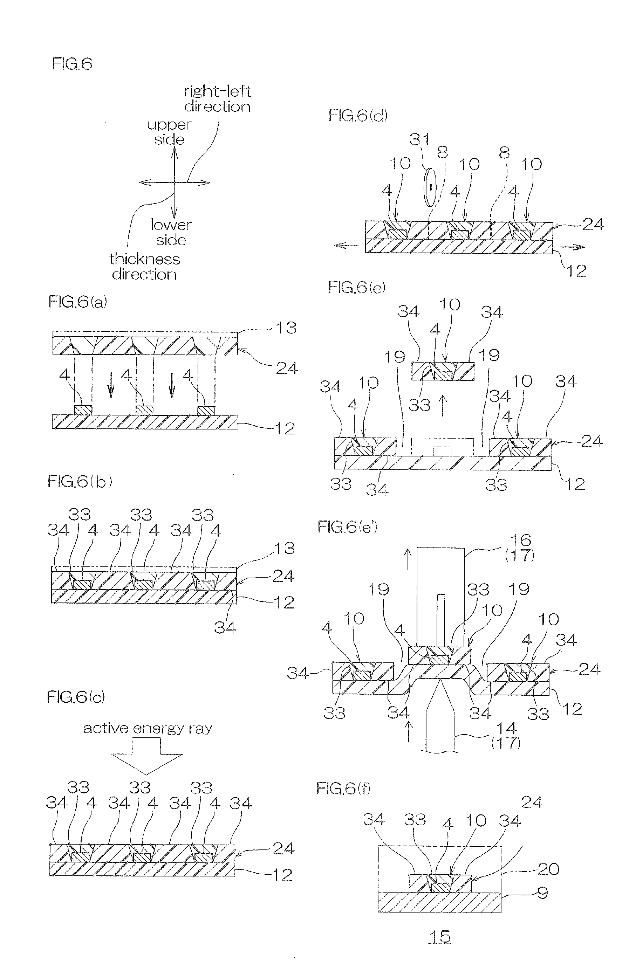

FIG. 6 shows process drawings for illustrating a fourth embodiment of a method for producing a phosphor layer-covered LED of the present invention:
FIG. 6 (a) illustrating a step of disposing LEDs on a support sheet (an LED disposing step),
FIG. 6 (b) illustrating a step of disposing an embedding-reflector sheet on the support sheet (a sheet disposing step),
FIG. 6 (c) illustrating a step of applying an active energy ray to the embedding-reflector sheet to cure embedding portions and encapsulating the LEDs by the embedding portions (an encapsulating step),
FIG. 6 (d) illustrating a step of cutting a reflector portion (a cutting step),
FIG. 6 (e) illustrating a step of peeling phosphor sheet-covered LEDs each including the reflector portion from the support sheet (an LED peeling step),
FIG. 6 (e') illustrating a step of describing the details of a state of peeling the phosphor sheet-covered LEDs from the support sheet using a pick-up device in the LED peeling step in FIG. 6 (e), and
FIG. 6 (f) illustrating a step of mounting the phosphor sheet-covered LED including the reflector portion on a board (a mounting step).

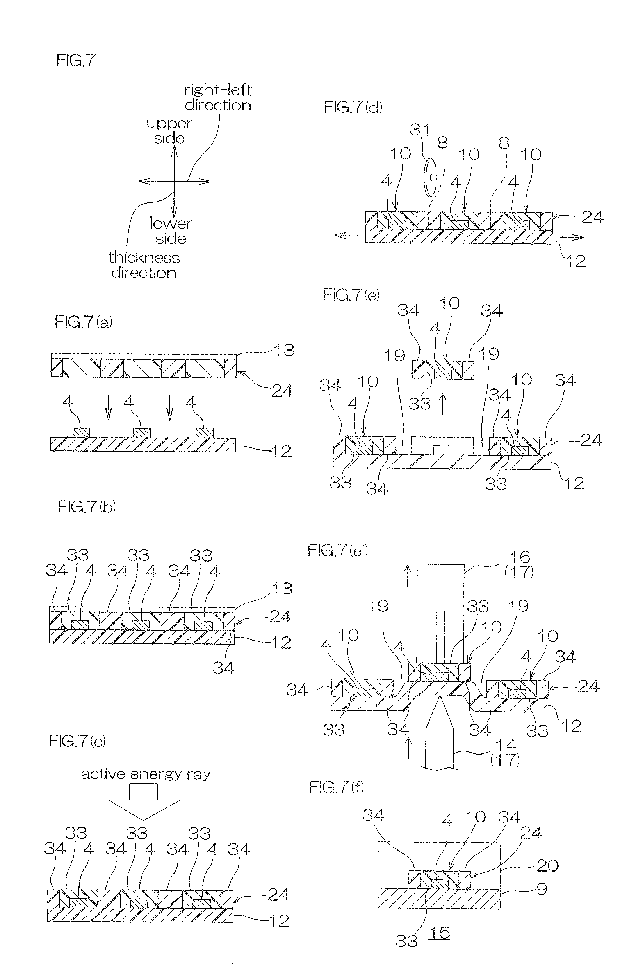

FIG. 7 shows process drawings for illustrating a fifth embodiment of a method for producing a phosphor layer-covered LED of the present invention:
FIG. 7 (a) illustrating a step of disposing LEDs on a support sheet (an LED disposing step),
FIG. 7 (b) illustrating a step of disposing an embedding-reflector sheet on the support sheet (a sheet disposing step),
FIG. 7 (c) illustrating a step of embedding the LEDs by embedding portions (a sheet disposing step),
FIG. 7 (d) illustrating a step of encapsulating the LEDs by the embedding portions (an encapsulating step) and a step of cutting a reflector portion (a cutting step),
FIG. 7 (e) illustrating a step of peeling phosphor sheet-covered LEDs each including the reflector portion from the support sheet (an LED peeling step),
FIG. 7 (e') illustrating a step of describing the details of a state of peeling the phosphor sheet-covered LEDs from the support sheet using a pick-up device in the LED peeling step in FIG. 7 (e), and
FIG. 7 (f) illustrating a step of mounting the phosphor sheet-covered LED including the reflector portion on a board (a mounting step).

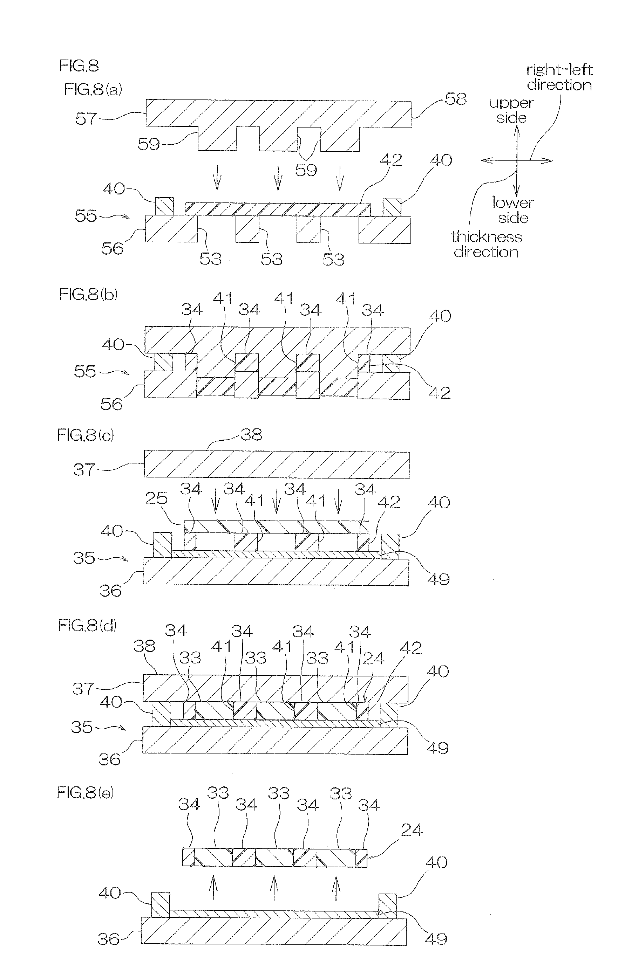

FIG. 8 shows process drawings for illustrating a method for producing the embedding-reflector sheet shown in FIG. 7 (a):
FIG. 8 (a) illustrating a step of disposing a reflector sheet on a punching device,
FIG. 8 (b) illustrating a step of stamping out the reflector sheet to form a reflector portion,
FIG. 8 (c) illustrating a step of disposing a phosphor sheet on the reflector portion,
FIG. 8 (d) illustrating a step of pressing the phosphor sheet to form embedding portions, and
FIG. 8 (e) illustrating a step of peeling the embedding-reflector sheet from a releasing sheet.

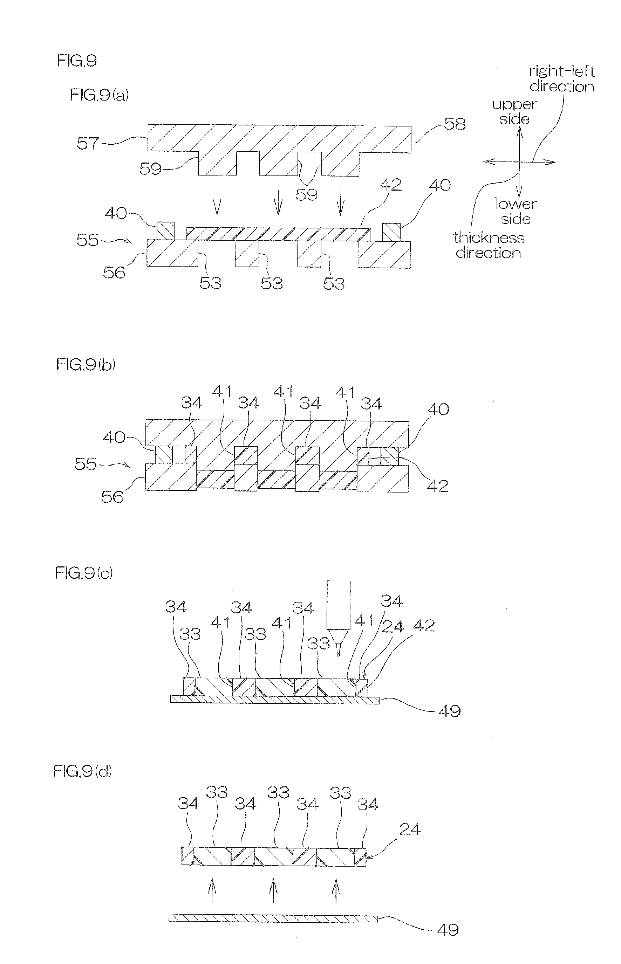

FIG. 9 shows process drawings for illustrating a method for producing an embedding-reflector sheet used in a sixth embodiment of a method for producing a phosphor layer-covered LED of the present invention:
FIG. 9 (a) illustrating a step of disposing a reflector sheet on a punching device,
FIG. 9 (b) illustrating a step of stamping out the reflector sheet to form a reflector portion,
FIG. 9 (c) illustrating a step of potting a varnish of a phosphor resin composition into through holes, and
FIG. 9 (d) illustrating a step of peeling the embedding-reflector sheet from a releasing sheet.

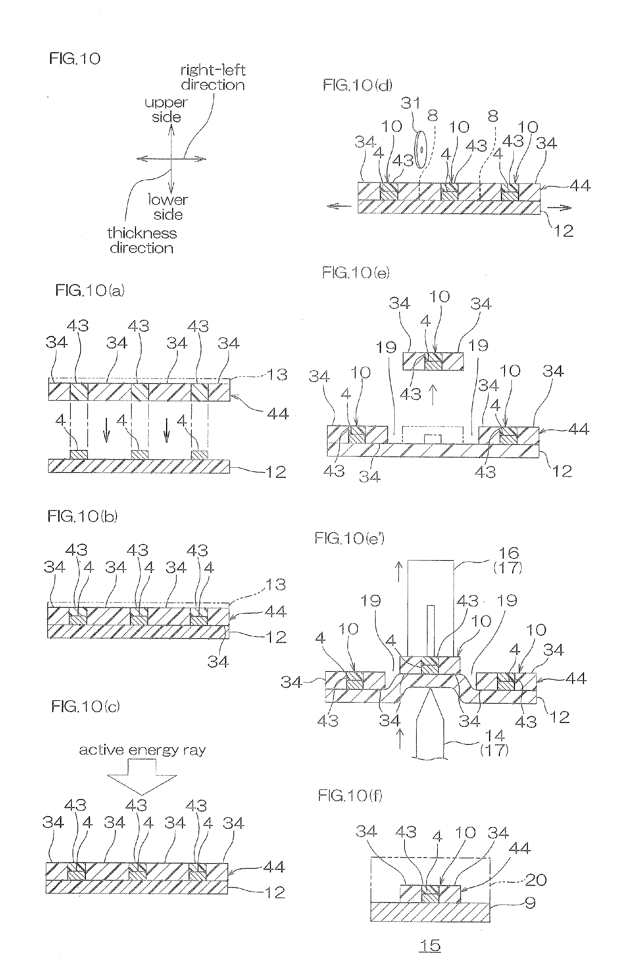

FIG. 10 shows process drawings for illustrating a seventh embodiment of a method for producing a phosphor layer-covered LED of the present invention:
FIG. 10 (a) illustrating a step of disposing LEDs on a support sheet (an LED disposing step),
FIG. 10 (b) illustrating a step of disposing a cover-reflector sheet on the support sheet (a sheet disposing step),
FIG. 10 (c) illustrating a step of curing cover portions (a curing step),
FIG. 10 (d) illustrating a step of cutting a reflector portion (a cutting step),
FIG. 10 (e) illustrating a step of peeling phosphor sheet-covered LEDs each including the reflector portion from the support sheet (an LED peeling step),
FIG. 10 (e') illustrating a step of describing the details of a state of peeling the phosphor sheet-covered LEDs from the support sheet using a pick-up device in the LED peeling step in FIG. 10 (e), and
FIG. 10 (f) illustrating a step of mounting the phosphor sheet-covered LED including the reflector portion on a board (a mounting step).

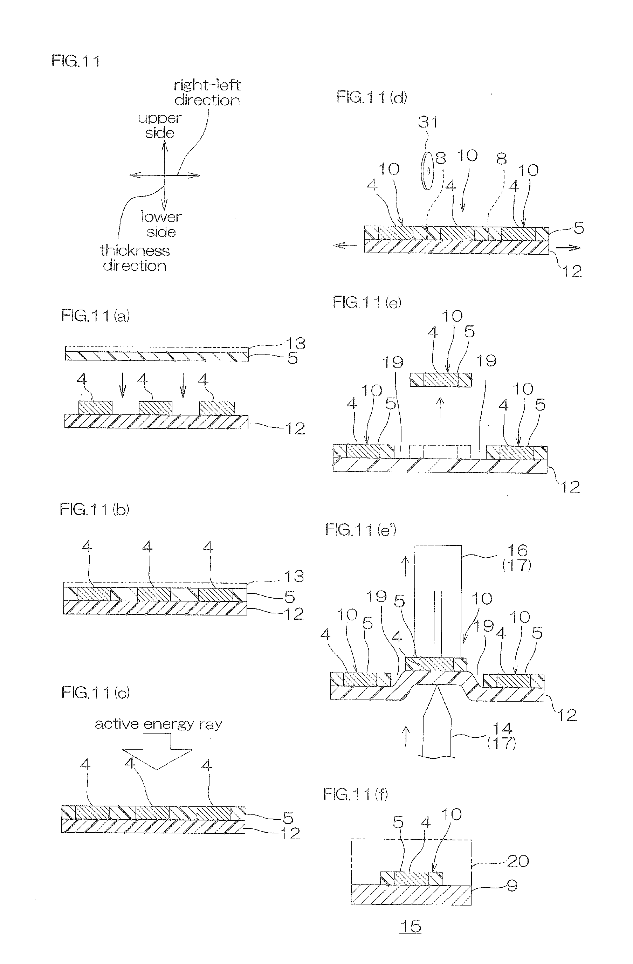

FIG. 11 shows process drawings for illustrating an eighth embodiment of a method for producing a phosphor layer-covered LED of the present invention:
FIG. 11 (a) illustrating a step of disposing LEDs on a support sheet (an LED disposing step),
FIG. 11 (b) illustrating a step of disposing a phosphor sheet on the support sheet so as to cover the side surfaces of the LEDs (a sheet disposing step),
FIG. 11 (c) illustrating a step of curing the phosphor sheet (a curing step),
FIG. 11 (d) illustrating a step of cutting the phosphor sheet (a cutting step),
FIG. 11 (e) illustrating a step of peeling phosphor sheet-covered LEDs from the support sheet (an LED peeling step), and
FIG. 11 (e') illustrating a step of describing the details of a state of peeling the phosphor sheet-covered LEDs from the support sheet using a pick-up device in the LED peeling step in FIG. 11 (e), and
FIG. 11 (f) illustrating a step of mounting the phosphor sheet-covered LED on a board (a mounting step).

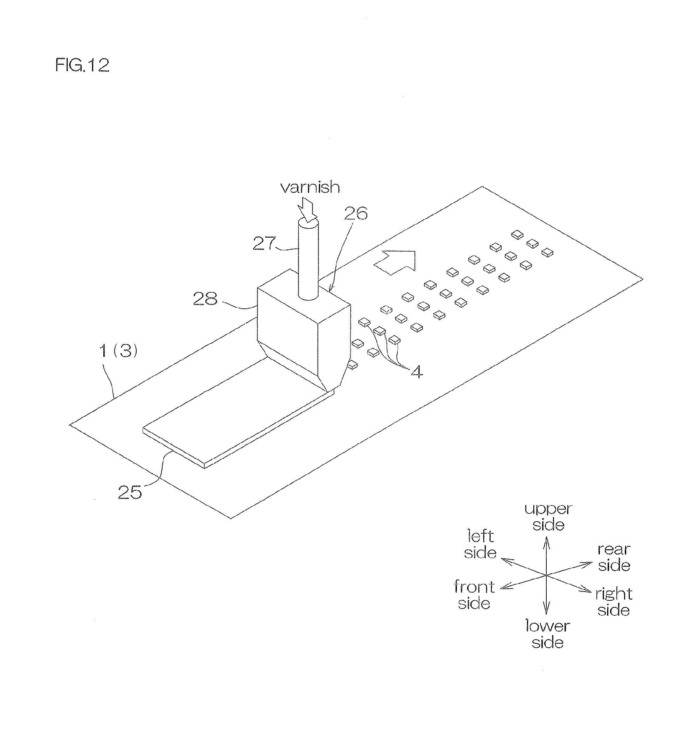

FIG. 12 shows a perspective view of a dispenser used in a ninth embodiment of a method for producing a phosphor layer-covered LED of the present invention.

### DETAILED DESCRIPTION OF THE INVENTION

### <First Embodiment>

In FIG. 1, the up-down direction of the paper surface is referred to as an up-down direction (a first direction, a thickness direction); the right-left direction of the paper surface is referred to as a right-left direction (a second direction, a direction perpendicular to the first direction); and the paper thickness direction of the paper is referred to as a front-rear direction (a third direction, a direction perpendicular to the first direction and the second direction). Directions and direction arrows in FIG. 2 and the subsequent figures are in conformity with the above-described directions and the direction arrows in FIG. 1.

FIG. 1 shows process drawings for illustrating a first embodiment of a method for producing a phosphor layer-covered LED of the present invention.

As shown in FIGS. 1 (a) to 1 (e), a method for producing a phosphor sheet-covered LED 10 that is one example of a phosphor layer-covered LED includes the steps of disposing LEDs 4 on the upper surface (at one surface in the thickness direction) of a support sheet 12 (ref: FIG. 1 (a)) (an LED disposing step); disposing a phosphor sheet 5 on the upper surface (at one surface in the thickness direction) of the support sheet 12 so as to cover the LEDs 4 (one example of a layer disposing step, ref: FIG. 1 (b) (a sheet disposing step); applying an active energy ray to the phosphor sheet 5 to encapsulate the LEDs 4 by the phosphor sheet 5 (one example of a curing step, ref: FIG. 1 (c)) (an encapsulating step); cutting the phosphor sheet 5 corresponding to each of the LEDs 4 (ref: FIG. 1 (d)) (a cutting step); and peeling the phosphor sheet-covered LEDs 10 from the support sheet 12 (ref: FIG. 1 (e)) (an LED peeling step).

In the following, the steps are described in detail.

### <LED Disposing Step>

As shown in FIG. 1 (a), the support sheet 12 is formed into a sheet shape extending in the plane direction (a direction perpendicular to the thickness direction, that is, the right-left direction and the front-rear direction). The support sheet 12 is formed into a generally rectangular shape in plane view that is the same as or is larger than the phosphor sheet 5 to be described next. To be specific, the support sheet 12 is formed into a generally rectangular sheet shape in plane view.

The support sheet 12 can be also selected from a sheet having low heat resistance because the heat resistance with respect to thermal curing of the phosphor sheet 5 to be described later is not required. The support sheet 12 is capable of supporting the LEDs 4 and is also capable of stretching in the plane direction. The support sheet 12 may be a thermal release sheet in which the pressure-sensitive adhesive force is capable of being reduced by heating (to be specific, a thermal release sheet such as REVALPHA (manufactured by NITTO DENKO CORPORATION)) or an active energy ray irradiation release sheet in which the pressure-sensitive adhesive force is capable of being reduced by application of an active energy ray (for example, an ultraviolet ray and an electron beam) (to be specific, an active energy ray irradiation release sheet described in Japanese Unexamined Patent Publication No. 2005-286003 or the like). When the support sheet 12 is an active energy ray irradiation release sheet, an active energy ray curable resin and the irradiation conditions are selected so that the pressure-sensitive adhesive force of the support sheet 12 is not reduced by application of the active energy ray to the phosphor sheet 5.

In a size of the support sheet 12, the maximum length thereof is, for example, 10 mm or more and 300 mm or less.

The support sheet 12 has a tensile elasticity at 23°C of, for example, 1 ×10⁴ Pa or more, or preferably 1 ×10⁵ Pa or more, and of, for example, 1 ×10⁹ Pa or less. When the tensile elasticity of the support sheet 12 is not less than the above-described lower limit, the stretchability of the support sheet 12 in the plane direction is secured and the stretching (ref: FIG. 1 (e)) of the support sheet 12 in the plane direction to be described later can be smoothly performed.

The thickness of the support sheet 12 is, for example, 0.1 mm or more, or preferably 0.2 mm or more, and is, for example, 1 mm or less, or preferably 0.5 mm or less.

Each of the LEDs 4 is, for example, formed into a generally rectangular shape in sectional view and a generally rectangular shape in plane view with the thickness shorter than the length in the plane direction (the maximum length). The lower surface of each of the LEDs 4 is formed of a bump that is not shown. An example of the LEDs 4 includes blue light emitting diode elements that emit blue light.

The maximum length in the plane direction of each of the LEDs 4 is, for example, 0.1 mm or more and 3 mm or less. The thickness thereof is, for example, 0.05 mm or more and 1 mm or less.

In the LED disposing step, for example, a plurality of the LEDs 4 are disposed in alignment on the upper surface of the support sheet 12. To be specific, a plurality of the LEDs 4 are disposed on the upper surface of the support sheet 12 in such a manner that a plurality of the LEDs 4 are arranged at equal intervals to each other in the front-rear and the right-left directions in plane view. The LEDs 4 are attached to the upper surface of the support sheet 12 so that the bumps thereof that are not shown are opposed to the upper surface of the support sheet 12. In this way, the LEDs 4 are supported at (pressure-sensitively adhere to) the upper surface of the support sheet 12 so that the alignment state thereof is retained.

The gap between the LEDs 4 is, for example, 0.05 mm or more and 2 mm or less.

### <Sheet Disposing Step>

The sheet disposing step is performed after the LED disposing step.

In the sheet disposing step shown in FIG. 1 (b), the phosphor sheet 5 is formed from a phosphor resin composition containing an active energy ray curable resin and a phosphor into a sheet shape.

The active energy ray curable resin is a curable resin that is capable of being cured by application of an active energy ray. To be specific, an example thereof includes a silicone semi-cured material. The silicone semi-cured material is obtained as a sheet by heating a first silicone resin composition or a second silicone resin composition.

In the following, the first silicone resin composition and the second silicone resin composition are described in detail.

### [First Silicone Resin Composition]

The first silicone resin composition contains, for example, a first polysiloxane containing at least one pair of condensable substituted groups that is capable of condensation by heating and at least one addable substituted group that is capable of addition by an active energy ray and a second polysiloxane containing at least one addable substituted group that is capable of addition by an active energy ray and makes one pair with the addable substituted group in the first polysiloxane.

An example of the one pair of condensable substituted groups includes combination (a first combination group) of at least one substituted group selected from the group consisting of a hydroxyl group (-OH), an alkoxy group, an acyloxy group, an amino group (-NH₂), an alkylamino group, an alkenyloxy group, and a halogen atom and a hydroxyl group.

The alkoxy group is represented by -OR¹. R¹ represents an alkyl group or a cycloalkyl group. An example of the alkyl group includes a straight chain or branched chain alkyl group having 1 or more and 20 or less carbon atoms such as a methyl group, an ethyl group, a propyl group, an isopropyl group, a butyl group, an isobutyl group, a pentyl group, and a hexyl group. Preferably, an alkyl group having 1 or more carbon atoms is used, more preferably, an alkyl group having 10 or less carbon atoms is used, or further more preferably, an alkyl group having 6 or less carbon atoms is used. An example of the cycloalkyl group includes a cycloalkyl group having 3 or more and 6 or less carbon atoms such as a cyclopentyl group and a cyclohexyl group.

An example of the alkoxy group includes an alkoxy group containing a straight chain or branched chain alkyl group having 1 or more and 20 or less carbon atoms such as a methoxy group, an ethoxy group, a propoxy group, an isopropoxy group, a butoxy group, an isobutoxy group, a pentyloxy group, and a hexyloxy group.

An example of the alkoxy group also includes an alkoxy group containing a cycloalkyl group having 3 or more and 6 or less carbon atoms such as a cyclopentyloxy group and a cyclohexyloxy group.

As the alkoxy group, preferably, in view of easy preparation and thermal stability, an alkoxy group containing an alkyl group having 1 or more carbon atoms is used, more preferably, an alkoxy group containing an alkyl group having 10 or less carbon atoms is used, further more preferably, an alkyl group having 6 or less carbon atoms is used, or even more preferably, a methoxy group is used.

The acyloxy group is represented by -OCOR¹. R¹ represents the above-described alkyl group or cycloalkyl group. Preferably, as R¹, an alkyl group is used.

Examples of the acyloxy group include an acetoxy group (-OCOCH₃), -OCOC₂H₅, and -OCOC₃H₇. Preferably, an acetoxy group is used.

Examples of the alkylamino group include a monoalkylamino group and a dialkylamino group.

The monoalkylamino group is represented by -NR²H. R² represents an alkyl group or a cycloalkyl group. Preferably, as R², an alkyl group is used. An example of the monoalkylamino group includes a monoalkylamino group having 1 or more and 10 or less carbon atoms of an N-substituted alkyl group such as a methylamino group, an ethylamino group, an n-propylamino group, and an isopropylamino group.

The dialkylamino group is represented by -NR². R² represents alkyl groups or cycloalkyl groups that may be the same or different from each other. R² is the same as that described above. An example of the dialkylamino group includes a dialkylamino group having 1 or more and 10 or less carbon atoms of an N,N-substituted alkyl such as a dimethylamino group, a diethylamino group, a di-n-propylamino group, a diisopropylamino group, an ethylmethylamino group, a methyl-n-propylamino group, and a methylisopropylamino group.

As the alkylamino group, preferably, a dialkylamino group is used, more preferably, a dialkylamino group having the same number of carbon atoms of N,N-substituted alkyl is used, or further more preferably, a dimethylamino group is used.

The alkenyloxy group is represented by -OCOR³. R³ represents an alkyl group or a cycloalkenyl group. An example of the alkenyl group includes an alkenyl group having 3 or more and 10 or less carbon atoms such as a vinyl group, an allyl group, a propenyl group, an isopropenyl group, a butenyl group, a pentenyl group, a hexenyl group, a heptenyl group, and an octenyl group. An example of the cycloalkenyl group includes a cycloalkenyl group having 3 or more and 10 or less carbon atoms such as a cyclohexenyl group, a cyclooctenyl group, and a norbornenyl group.

As the alkenyloxy group, preferably, an alkenyloxy group containing an alkenyl group having 2 or more and 10 or less carbon atoms is used, or more preferably, an isopropenyloxy group is used.

Examples of the halogen atom include a fluorine atom, a chlorine atom, a bromine atom, and an iodine atom. Preferably, a chlorine atom is used.

To be specific, an example of the first combination group includes one pair of combinations such as combination of hydroxyl groups with themselves, combination of an alkoxy group and a hydroxyl group, combination of an acyloxy group and a hydroxyl group, combination of an amino group and a hydroxyl group, combination of an alkylamino group and a hydroxyl group, combination of an alkenyloxy group and a hydroxyl group, and combination of a halogen atom and a hydroxyl group.

Furthermore, an example of the first combination group also includes two pairs (to be specific, the total of two pairs of one pair of an alkoxy group and a hydroxyl group and the other pair of an acyloxy group and a hydroxyl group) or more of combinations such as combination of an alkoxy group, an acyloxy group, and a hydroxyl group.

As the first combination group, preferably, combination of hydroxyl groups with themselves and combination of an alkoxy group and a hydroxyl group are used, more preferably, combination of an alkoxy group and a hydroxyl group is used, further more preferably, combination of an alkoxy group containing an alkyl group having 1 or more and 10 or less carbon atoms and a hydroxyl group is used, or particularly preferably, combination of a methoxy group and a hydroxyl group is used.

In the one pair of condensable substituted groups made of the first combination group, two silicon atoms are bonded to each other via an oxide atom by condensation represented by the following formula (1), that is, silanol condensation.

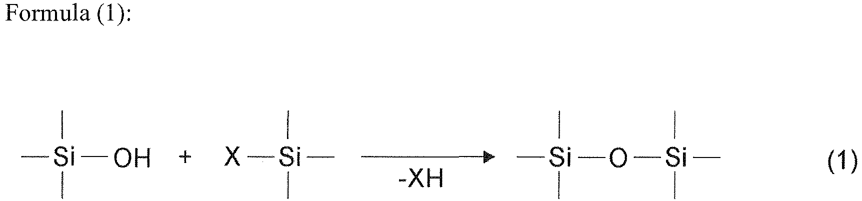

X= -OH, -OR¹,-OCOR¹,-NH₂,-NR²H,-NR²₂,-OCOR³, halogen atom
(where, in formula, R¹ to R³ are the same as those described above.)

An example of the one pair of condensable substituted groups includes combination (a second combination group) of at least one substituted group selected from a hydroxyl group and an alkoxy group and a hydrogen atom.

An example of the alkoxy group includes the alkoxy group illustrated in the first combination group.

To be specific, an example of the second combination group includes one pair of combinations such as combination of a hydroxyl group and a hydrogen atom and combination of an alkoxy group and a hydrogen atom.

Furthermore, an example of the second combination group also includes two pairs (to be specific, the total of two pairs of one pair of a hydroxyl group and a hydrogen atom and the other pair of an alkoxy group and a hydrogen atom) or more of combinations such as combination of a hydroxyl group, an alkoxy group, and a hydrogen atom.

In one pair of condensable substituted groups made of the second combination group, two silicon atoms are bonded to each other via an oxide atom by condensation represented by the following formula (2), that is, hydrosilane condensation.

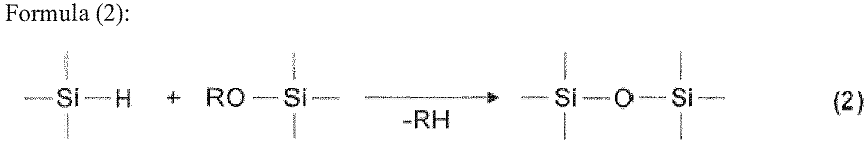

OR= OH, -OR¹
(where, in formula, R¹ is the same as that described above.)

The above-described first combination groups and second combination groups can be contained in the first polysiloxane alone or in combination of a plurality of groups.

Each of the condensable substituted groups is bonded to a silicon atom that is at the end of the main chain, which constitutes a molecule in the first polysiloxane; in the middle of the main chain; and/or in a side chain that branches off from the main chain. Preferably, one condensable substituted group (preferably, a hydroxyl group) is bonded to the silicon atoms at both ends of the main chain and the other condensable substituted group (preferably, an alkoxy group) is bonded to the silicon atom in the middle of the main chain (ref: Formula (16) to be described later).

In one pair of addable substituted groups, at least one piece of one addable substituted group is contained in the first polysiloxane and at least one piece of the other addable substituted group is contained in the second polysiloxane.

Examples of the one pair of addable substituted groups include combination of a hydrosilyl group and an ethylenically unsaturated group-containing group, combination of (meth)acryloyl group-containing groups with themselves, combination of epoxy group-containing groups with themselves, and combination of a thiol group-containing group and an ethylenically unsaturated group-containing group.

The hydrosilyl group is represented by -SiH and is a group in which a hydrogen atom is directly bonded to a silicon atom.

The ethylenically unsaturated group-containing group contains, in a molecule, an ethylenically unsaturated group. Examples of the ethylenically unsaturated group-containing group include the above-described alkenyl group and cycloalkenyl group. Preferably, an alkenyl group is used, or more preferably, a vinyl group is used.

The (meth)acryloyl group-containing group contains, in a molecule, a methacryloyl group (CH₂=C(CH₃)COO-) and/or an acryloyl group (CH₂=CHCOO-) and to be specific, is represented by the following formula (3).

Formula (3): CH₂ = CYCOO - R⁴- (3)

(where, in formula, Y represents a hydrogen atom or a methyl group and R⁴ represents a divalent hydrocarbon group selected from a saturated hydrocarbon group and an aromatic hydrocarbon group.)

Examples of the divalent saturated hydrocarbon group include an alkylene group having 1 or more and 6 or less carbon atoms such as a methylene group, an ethylene group, a propylene group, and a butylene group and a cycloalkylene group having 3 or more and 8 or less carbon atoms such as a cyclopentylene group and a cyclohexylene group.

An example of the divalent aromatic hydrocarbon group includes an arylene group having 6 or more and 10 or less carbon atoms such as a phenylene group and a naphthylene group.

As the divalent hydrocarbon group, preferably, a divalent saturated hydrocarbon group is used, more preferably, an alkylene group is used, or further more preferably, a propylene group is used.

To be specific, an example of the (meth)acryloyl group-containing group includes a 3-(meth)acryloxypropyl group.

The epoxy group-containing group contains, in a molecule, an epoxy group. Examples of the epoxy group-containing group include an epoxy group, a glycidyl ether group, and an epoxy cycloalkyl group. Preferably, a glycidyl ether group and an epoxy cycloalkyl group are used.

The glycidyl ether group is a glycidoxy alkyl group, for example, represented by formula (4).

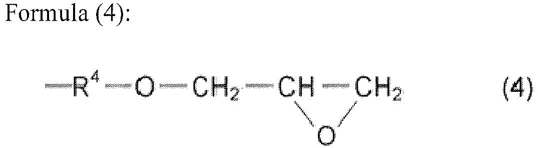

(where, in formula (4), R⁴ represents a divalent hydrocarbon group selected from a saturated hydrocarbon group and an aromatic hydrocarbon group.)

The divalent hydrocarbon group represented by R⁴ is the same as the divalent hydrocarbon group in the above-described formula (3).

An example of the glycidyl ether group includes a 3-glycidoxypropyl group.

An example of the epoxy cycloalkyl group includes an epoxy cyclohexyl group represented by the following formula (5).

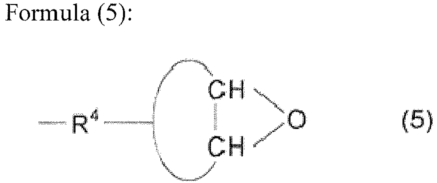

(where, in formula, R⁴ represents a divalent hydrocarbon group selected from a saturated hydrocarbon group and an aromatic hydrocarbon group.)

An example of the divalent saturated hydrocarbon group includes the divalent hydrocarbon group in the above-described formula (3). Preferably, the above-described alkylene group having 1 or more and 6 or less carbon atoms is used, or more preferably, an ethylene group is used.

To be specific, an example of the epoxy cycloalkyl group includes a 2-(3,4-epoxy cyclohexyl)ethyl group.

The thiol group-containing group contains, in a molecule, a thiol group (-SH). Examples thereof include a thiol group and a mercaptoalkyl group such as mercaptomethyl, mercaptoethyl, and mercaptopropyl.

One addable substituted group is replaced with the end and the middle of the main chain and/or a side chain in the first polysiloxane. The other addable substituted group is replaced with or positioned at the end and the middle of the main chain and/or a side chain in the second polysiloxane.

An example of the addable substituted group includes one pair or two or more pairs of combinations described above.

As one pair of addable substituted groups, in view of heat resistance and transparency, preferably, combination of a hydrosilyl group and an alkenyl group is used.

As shown in the following formulas (6) to (9), one pair of addable substituted groups is subjected to addition.

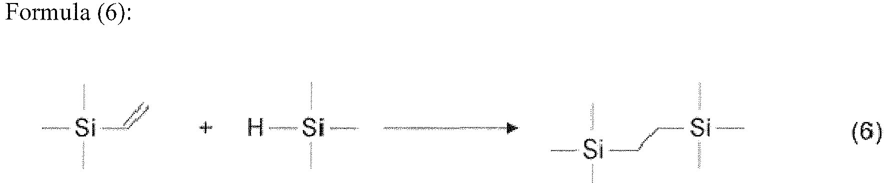

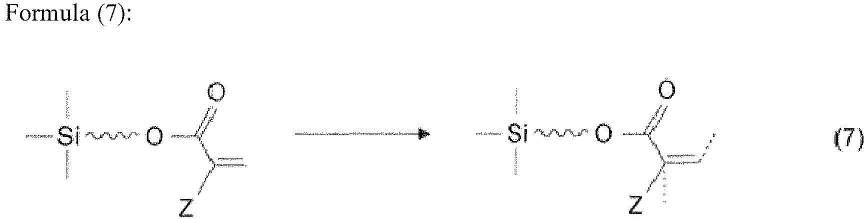

### (where, in formula, Z represents a hydrogen atom or a methyl group.)

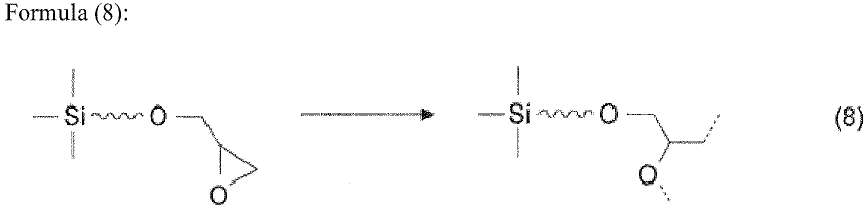

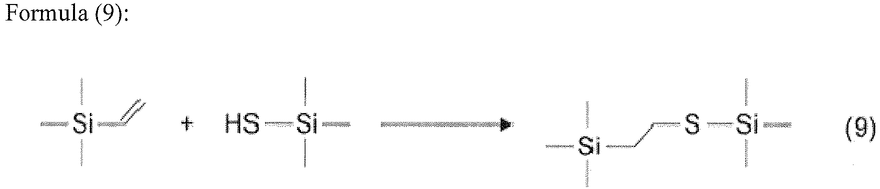

To be specific, when one pair of addable substituted groups is combination of a hydrosilyl group and an alkenyl group (to be specific, a vinyl group), as shown by the above-described formula (6), hydrosilylation (hydrosilylation addition) is performed.

When one pair of addable substituted groups is combination of (meth)acryloyl groups with themselves, as shown by the above-described formula (7), polymerization (addition polymerization) is performed.

When one pair of addable substituted groups is combination of glycidyl ether groups with themselves, as shown by the above-described formula (8), ring-opening addition is performed based on ring opening of an epoxy group.

When one pair of addable substituted groups is combination of a thiol group and an alkenyl group (to be specific, a vinyl group), as shown by the above-described formula (9), a thiol-ene reaction (addition) is performed.

To be specific, the first polysiloxane is represented by the following formula (10).

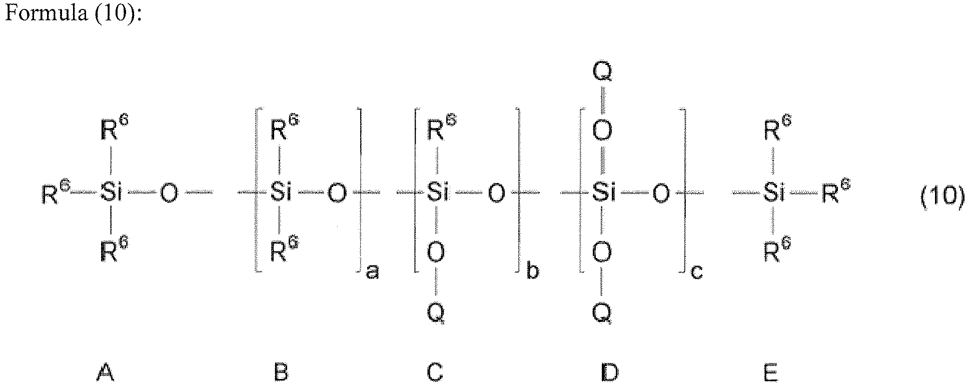

(where, in formula, R⁶ represents a monovalent hydrocarbon group selected from a saturated hydrocarbon group and an aromatic hydrocarbon group; a condensable substituted group; and/or an addable substituted group. SiR⁶ may represent an addable substituted group. A to E represent a constituent unit, A and E represent an end unit, and B to D represent a repeating unit. Q represents a constituent unit of B to E. "a" + "b" + "c" is an integer of 1 or more. Of a plurality of R⁶s, at least one pair of R⁶s represents a condensable substituted group, and at least one R⁶ or at least one SiR⁶ represents an addable substituted group.)

In formula (10), of the monovalent hydrocarbon groups represented by R⁶, examples of the monovalent saturated hydrocarbon group include an alkyl group and a cycloalkyl group. Examples of the alkyl group and the cycloalkyl group include the same alkyl group and cycloalkyl group as those illustrated in the above-described R¹, respectively.

In formula (10), of the monovalent hydrocarbon groups represented by R⁶, an example of the monovalent aromatic hydrocarbon group includes an aryl group having 6 or more and 10 or less carbon atoms such as a phenyl group and a naphthyl group.

As the monovalent hydrocarbon group, preferably, methyl and phenyl are used.

"a" is, for example, an integer of 0 or more, preferably an integer of 1 or more, or more preferably an integer of 2 or more. "a" is also, for example, an integer of 100000 or less, preferably an integer of 10000 or less.

"b" is, for example, an integer of 0 or more and 100000 or less, or preferably an integer of 0 or more and 10000 or less.

"c" is, for example, an integer of 0 or more and 100000 or less, or preferably an integer of 0 or more and 10000 or less.

"a" + "b" + "c" is preferably an integer of 1 or more and 100000 or less, or more preferably an integer of 1 or more and 10000 or less. That is, of "a" to "c", at least one is an integer of 1 or more.

Examples of the condensable substituted group represented by R⁶ and the addable substituted group represented by R⁶ or SiR⁶ include the above-described condensable substituted group and addable substituted group, respectively.

The first polysiloxane is, for example, prepared by allowing a first silicon compound containing both at least one condensable substituted group and at least one addable substituted group, and a second silicon compound containing at least one condensable substituted group to be partially subjected to condensation (ref: formula (16) to be described later).

The first silicon compound is, for example, represented by the following formula (11).

Formula (11): R ⁷ S i B ₙ X¹ _{3 - n} (11)

(where, in formula, R⁷ or SiR⁷ represents an addable substituted group; B represents a monovalent hydrocarbon group selected from a saturated hydrocarbon group and an aromatic hydrocarbon group; and X¹ represents a condensable substituted group. "n" represents 0 or 1.)

As the addable substituted group represented by R⁷ or SiR⁷, for example, the above-described addable substituted group is used; preferably, one of the substituted groups constituting one pair of addable substituted groups is used; more preferably, an ethylenicaly unsaturated group-containing group, a (meth)acryloyl group-containing group, and an epoxy group-containing group are used; further more preferably, an ethylenically unsaturated group-containing group is used; particularly preferably, an alkenyl group is used; or most preferably, a vinyl group is used.

As the condensable substituted group represented by X¹, for example, the above-described condensable substituted group is used; preferably, one of the substituted groups constituting one pair of condensable substituted groups is used; more preferably, a hydroxyl group, an alkoxy group, an acyloxy group, an amino group, an alkylamino group, an alkenyloxy group, and a halogen atom are used; or further more preferably, an alkoxy group is used.

As the alkoxy group represented by X¹, for example, in view of reactivity, preferably, an alkoxy group containing an alkyl group having 1 or more and 10 or less carbon atoms is used, or more preferably, an alkoxy group containing an alkyl group having 1 or more and 6 or less carbon atoms is used. To be specific, a methoxy group is used.

The monovalent hydrocarbon group represented by B is the same monovalent hydrocarbon group as that illustrated by R⁶ in formula (10).

When "n" is 0, the first silicon compound is represented by the following formula (12) and is defined as a trifunctional silicon compound containing three condensable substituted groups.

Formula (12): R ⁷ S i X ¹ ₃ (12)

(where, in formula, R⁷ or SiR⁷ represents an addable substituted group and X¹ represents a condensable substituted group.)

Examples of the trifunctional silicon compound include a vinyltrimethoxysilane, a vinyltriethoxysilane, an allyltrimethoxysilane, a propenyltrimethoxysilane, a norbornenyltrimethoxysilane, an octenyltrimethoxysilane, a 3-acryloxypropyltrimethoxysilane, a 3-methacryloxypropyltriethoxysilane, 3-methacryloxypropyltrimethoxysilane, a 3-glycidoxypropyltriethoxysilane, a 3-glycidoxypropyltrimethoxysilane, and 2-(3,4-epoxycyclohexyl)ethyltrimethoxysilane.

These trifunctional silicon compounds can be used alone or in combination of two or more.

As the trifunctional silicon compound, preferably, a vinyltrimethoxysilane in which R⁷ is a vinyl group and all of the X¹s are methoxy groups in the above-described formula (12) is used.

On the other hand, in the above-described formula (11), when "n" is 1, the first silicon compound is represented by the following formula (13) and is defined as a bifunctional silicon compound containing two condensable substituted groups.

Formula (13): R ⁷ S i B X ¹ ₂ (13)

(where, in formula, R⁷ or SiR⁷ represents an addable substituted group; B represents a monovalent hydrocarbon group selected from a saturated hydrocarbon group and an aromatic hydrocarbon group; and X¹ represents a condensable substituted group.)

R⁷, SiR⁷, B, and X¹ are the same as those described above.

Examples of the bifunctional silicon compound include a vinyldimethoxymethylsilane, a vinyldiethoxymethylsilane, an allyldimethoxymethylsilane, a propenyldimethoxymethylsilane, a norbornenyldimethoxymethylsilane, an octenyldimethoxymethylsilane, an octenyldiethoxymethylsilane, a 3-acryloxypropyldimethoxymethylsilane, a 3-methacryloxypropyldimethoxymethylsilane, a 3-methacryloxypropyldimethoxymethylsilane, a 3-glycidoxypropyldiethoxymethylsilane, a 3-glycidoxypropyldimethoxymethylsilane, and a 2-(3,4-epoxycyclohexyl)ethyldimethoxymethylsilane.

These bifunctional silicon compounds can be used alone or in combination of two or more.

As the bifunctional silicon compound, preferably, a vinyldimethoxymethylsilane in which R⁷ is a vinyl group, B is a methyl group, and all of the X¹s are methoxy groups in the above-described formula (13) is used.

A commercially available product can be used as the first silicon compound and a first silicon compound synthesized in accordance with a known method can be also used.

These first silicon compounds can be used alone or in combination of two or more.

To be specific, a trifunctional silicon compound is used alone, a bifunctional silicon compound is used alone, or a trifunctional silicon compound and a bifunctional silicon compound are used in combination. Preferably, a trifunctional silicon compound is used alone, and a trifunctional silicon compound and a bifunctional silicon compound are used in combination.

An example of the second silicon compound includes a polysiloxane containing at least two condensable substituted groups, to be specific, containing a condensable substituted group bonded to a silicon atom at the end of the main chain and/or a condensable substituted group bonded to a silicon atom in a side chain that branches off from the main chain.

Preferably, the second silicon compound contains a condensable substituted group bonded to the silicon atoms at both ends of the main chain (a bifunctional silicon compound).

The second silicon compound is a dual-end type polysiloxane (a bifunctional polysiloxane) represented by the following formula (14).

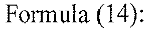

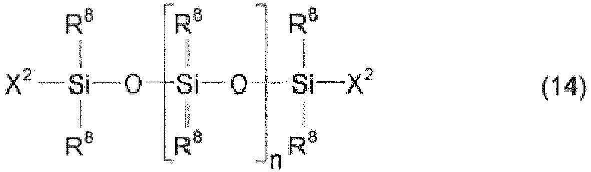

(where, in formula, R⁸ represents a monovalent hydrocarbon group selected from a saturated hydrocarbon group and an aromatic hydrocarbon group; X² represents a condensable substituted group; and "n" represents an integer of 1 or more.)

In formula (14), an example of the monovalent hydrocarbon group represented by R⁸ includes the monovalent hydrocarbon group illustrated by R⁶ in the above-described formula (10). Preferably, methyl and phenyl are used.

In formula (14), an example of the condensable substituted group represented by X² includes the condensable substituted group illustrated by R⁶ in the above-described formula (10). Preferably, a hydroxyl group and a hydrogen atom are used, or more preferably, a hydroxyl group is used.

When the condensable substituted group is a hydroxyl group, the dual-end type polysiloxane is defined as a polysiloxane containing silanol groups at both ends (a silicone oil containing silanol groups at both ends) represented by the following formula (15).

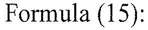

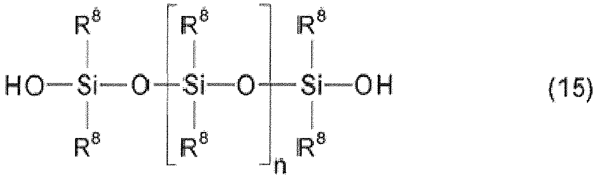

(where, in formula, R⁸ represents a monovalent hydrocarbon group selected from a saturated hydrocarbon group and an aromatic hydrocarbon group. "n" represents an integer of 1 or more.)

R⁸ is the same as that described above.

In the above-described formulas (14) and (15), "n" is, in view of stability and/or handling ability, preferably an integer of 1 or more and 10000 or less, or more preferably an integer of 1 or more and 1000 or less.

To be specific, examples of the dual-end type polysiloxane include a polydimethylsiloxane containing silanol groups at both ends, a polymethylphenylsiloxane containing silanol groups at both ends, and a polydiphenylsiloxane containing silanol groups at both ends.

A commercially available product can be used as the second silicon compound and a second silicon compound synthesized in accordance with a known method can be also used.

The number average molecular weight of the second silicon compound is, in view of stability and/or handling ability, for example, 100 or more, or preferably 200 or more, and is, for example, 1000000 or less, or preferably 100000 or less. The number average molecular weight is calculated by conversion based on standard polystyrene with a gel permeation chromatography. The number average molecular weight of materials, other than the second silicon compound, is also calculated in the same manner as described above.

In order to allow the first silicon compound and the second silicon compound to be partially subjected to condensation, a condensation material made of those is blended with a condensation catalyst.

The mixing ratio of the second silicon compound with respect to 100 parts by mass of the total amount of the first silicon compound and the second silicon compound (that is, the total amount of the condensation material) is, for example, 1 part by mass or more, preferably 50 parts by mass or more, or more preferably 80 parts by mass or more, and is, for example, 99.99 parts by mass or less, preferably 99.9 parts by mass or less, or more preferably 99.5 parts by mass or less.

The molar ratio (X²/X¹) of the condensable substituted group (X² in the above-described formula (14), to be specific, a hydroxyl group) in the second silicon compound to the condensable substituted group (X¹ in the above-described formula (11), to be specific, an alkoxy group) in the first silicon compound is, for example, 20/1 or less, or preferably 10/1 or less, and is, for example, 1/5 or more, preferably 1/2 or more, or most preferably substantially 1/1.

When the molar ratio is above the above-described upper limit, in a case where the first polysiloxane is obtained by allowing the first and the second silicon compounds to be partially subjected to condensation and thereafter, the first and the second polysiloxanes are completely subjected to condensation, a silicone semi-cured material having an appropriate toughness may not be obtained. On the other hand, when the molar ratio is below the above-described lower limit, the mixing proportion of the first silicon compound is excessively large, so that the heat resistance of a silicone cured material to be obtained may be reduced.

When the molar ratio is within the above-described range (preferably, substantially 1/1), the condensable substituted group (to be specific, an alkoxy group) in the first silicon compound and the condensable substituted group (to be specific, a hydroxyl group) in the second silicon compound can be completely subjected to condensation neither too much nor too little.

When the trifunctional silicon compound and the bifunctional silicon compound are used in combination, the ratio (the number of parts by mass of the bifunctional silicon compound/the number of parts by mass of the trifunctional silicon compound) of the bifunctional silicon compound to the trifunctional silicon compound, based on mass, is, for example, 70/30 or less, or preferably 50/50 or less, and is, for example, 1/99 or more, or preferably 5/95 or more. When the trifunctional silicon compound and the bifunctional silicon compound are used in combination, the molar ratio (X²/X¹) of the condensable substituted group (X² in the above-described formula (14), to be specific, a hydroxyl group) in the second silicon compound to the condensable substituted group (X¹ in the above-described formula (12), to be specific, an alkoxy group) in the trifunctional silicon compound is, for example, 20/1 or less, preferably 10/1 or less, and is, for example, 1/5 or more, preferably 1/2 or more, or most preferably substantially 1/1. On the other hand, when the trifunctional silicon compound and the bifunctional silicon compound are used in combination, the molar ratio (X²/X¹) of the condensable substituted group (X² in the above-described formula (14), to be specific, a hydroxyl group) in the second silicon compound to the condensable substituted group (X¹ in the above-described formula (13), to be specific, an alkoxy group) in the bifunctional silicon compound is, for example, 20/1 or less, or preferably 10/1 or less, and is, for example, 1/5 or more, preferably 1/2 or more, or most preferably substantially 1/1.

The condensation catalyst is not particularly limited as long as it is a catalyst that promotes condensation of the first silicon compound with the second silicon compound. Examples of the condensation catalyst include an acid, a base, and a metal catalyst.

An example of the acid includes an inorganic acid (a Broensted acid) such as a hydrochloric acid, an acetic acid, a formic acid, and a sulfuric acid. The acid includes a Lewis acid and an example of the Lewis acid includes an organic Lewis acid such as pentafluorophenyl boron, scandium triflate, bismuth triflate, scandium trifurylimide, oxovanadium triflate, scandium trifurylmethide, and trimethylsilyl trifurylimide.

Examples of the base include an inorganic base such as potassium hydroxide, sodium hydroxide, and potassium carbonate and tetramethylammonium hydroxide. Preferably, an organic base such as tetramethylammonium hydroxide is used.

Examples of the metal catalyst include an aluminum-based catalyst, a titanium-based catalyst, a zinc-based catalyst, and a tin-based catalyst. Preferably, a tin-based catalyst is used.

Examples of the tin-based catalyst include a carboxylic acid tin salt such as di (or bis)(carboxylic acid)tin (II) containing a straight chain or branched chain carboxylic acid having 1 or more and 20 or less carbon atoms including di(2-ethylhexanoate)tin (II), dioctanoate tin (II) (dicaprylic acid tin (II)), bis(2-ethylhexanoate)tin, bis(neodecanoate)tin, and tin oleate and an organic tin compound such as dibutylbis(2,4-pentanedionate)tin, dimethyltindiversatate, dibutyltindiversatate, dibutyltindiacetate (dibutyldiacetoxytin), dibutyltindioctoate, dibutylbis(2-ethylhexylmaleate)tin, dioctyldilauryltin, dimethyldineodecanoatetin, dibutyltindioleate, dibutyltindilaulate, dioctyltindilaulate, dioctyltindiversatate, dioctyltinbis (mercaptoacetic acid isooctyl ester)salt, tetramethyl-1,3-diacetoxydistannoxane, bis(triethyltin)oxide, tetramethyl-1,3-diphenoxydistannoxane, bis(tripropyltin)oxide, bis(tributyltin)oxide, bis(tributyltin)oxide, bis(triphenyltin)oxide, poly(dibutyltin maleate), diphenyltindiacetate, dibutyltin oxide, dibutyltindimethoxide, and dibutylbis(triethoxy)tin.

As the tin-based catalyst, preferably, a carboxylic acid tin salt is used, more preferably, di(carboxylic acid)tin (II) containing a straight chain or branched chain carboxylic acid having 1 or more and 20 or less carbon atoms is used, further more preferably, di(carboxylic acid)tin (II) containing a straight chain or branched chain carboxylic acid having 4 or more and 14 or less carbon atoms is used, or particularly preferably, di(carboxylic acid)tin (II) containing a branched chain carboxylic acid having 6 or more and 10 or less carbon atoms is used.

These condensation catalysts can be used alone or in combination.

A commercially available product can be used as the condensation catalyst. A condensation catalyst synthesized in accordance with a known method can be also used.

The condensation catalyst can be, for example, solved in a solvent to be prepared as a condensation catalyst solution. The concentration of the condensation catalyst in the condensation catalyst solution is adjusted to be, for example, 1 mass % or more and 99 mass % or less.

The mixing ratio of the condensation catalyst with respect to 100 mol of the second silicon compound is, for example, 0.001 mol or more, or preferably 0.01 mol or more, and is, for example, 50 mol or less, or preferably 5 mol or less.

Next, in this method, after the blending of the first silicon compound, the second silicon compound, and the condensation catalyst, the mixture is stirred and mixed at a temperature of, for example, 0°C or more, or preferably 10°C or more, and of, for example, 80°C or less, or preferably 75°C or less for, for example, 1 minute or more, or preferably 2 hours or more, and of, for example, 24 hours or less, or preferably 10 hours or less.

By the above-described mixing, the first and the second silicon compounds are partially subjected to condensation in the presence of the condensation catalyst.

To be specific, the condensable substituted group (X¹ in the above-described formula (11)) in the first silicon compound and the condensable substituted group (X² in the above-described formula (14)) in the second silicon compound are partially subjected to condensation.

To be more specific, when the condensable substituted group in the first silicon compound is an alkoxy group and the condensable substituted group in the second silicon compound is a hydroxyl group, as shown by the following formula (16), they are partially subjected to condensation.

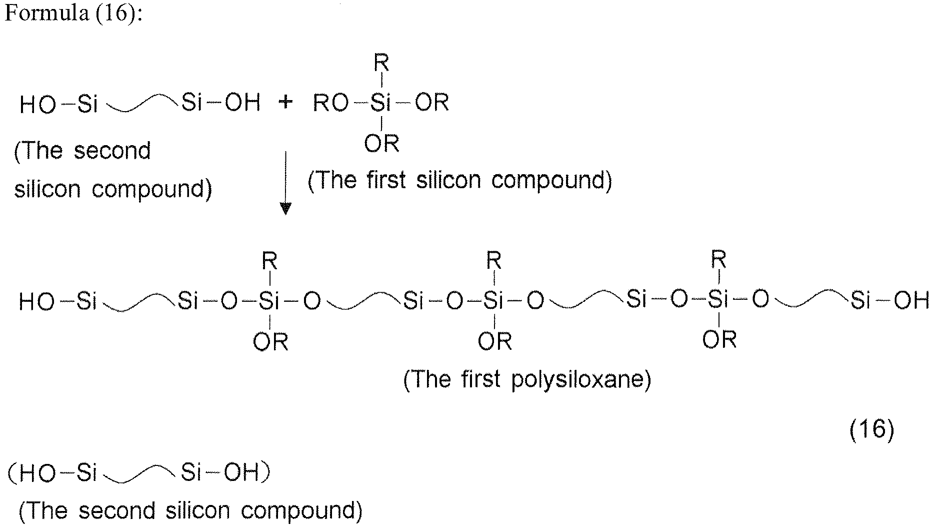

A portion in the second silicon compound is not subjected to condensation and remains to be subjected to condensation with the condensable substituted group in the first polysiloxane by next further condensation (a complete curing step).

The first polysiloxane obtained in this way is in a liquid state (in an oil state) and in an A-stage state.

An example of the second polysiloxane includes a side-chain type polysiloxane that is represented by the following formula (17) and contains at least one condensable substituted group in a side chain.

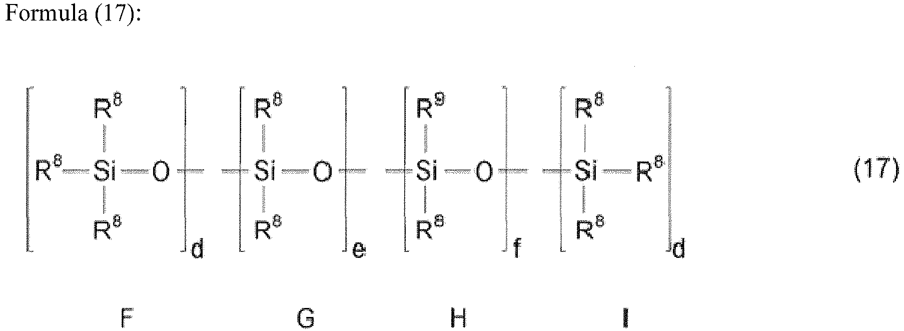

(where, in formula, F to I represent a constituent unit; F and I represent an end unit; and G and H represent a repeating unit. R⁸ represents a monovalent hydrocarbon group selected from a saturated hydrocarbon group and an aromatic hydrocarbon group, and R⁹ or SiR⁹ represents an addable substituted group. "d" is 0 or 1, "e" is an integer of 0 or more, and "f" is an integer of 1 or more. All of the R⁸s or the R⁹s may be the same or different from each other.)

In formula (17), an example of the monovalent hydrocarbon group represented by R⁸ includes the monovalent hydrocarbon group illustrated by R⁶ in the above-described formula (10). Preferably, methyl and phenyl are used.

In formula (17), as the addable substituted group represented by R⁹ or SiR⁹, for example, the above-described addable substituted group is used; preferably, the other of the substituted groups constituting one pair of addable substituted groups is used; more preferably, a hydrosilyl group and an ethylenically unsaturated group-containing group (to be specific, a vinyl group) are used; or further more preferably, a hydrosilyl group is used.

When "d" is 1, the side-chain type polysiloxane is a straight chain polysiloxane and when "d" is 0, the side-chain type polysiloxane is a cyclic polysiloxane.

Preferably, "d" is 1.

"e" represents the number of repeating unit in the constituent unit G and is, in view of reactivity, preferably an integer of 0 or more, or more preferably an integer of 1 or more, and is preferably an integer of 100000 or less, or more preferably an integer of 10000 or less.

"f" represents the number of repeating unit in the constituent unit H and is, in view of reactivity, preferably an integer of 1 or more, or more preferably an integer of 2 or more, and is, preferably an integer of 100000 or less, or more preferably an integer of 10000 or less.

The number average molecular weight of the side-chain type polysiloxane is, for example, in view of stability and handling ability, 100 or more and 1000000 or less, or preferably 100 or more and 100000 or less.

To be specific, examples of the side-chain type polysiloxane include a methylhydrogenpolysiloxane, a methylvinylpolysiloxane, a dimethylpolysiloxane-co-methylhydrogenpolysiloxane, a dimethylpolysiloxane-co-vinylmethylpolysiloxane, an ethylhydrogenpolysiloxane, a methylhydrogenpolysiloxane-co-methylphenylpolysiloxane, a methylvinylpolysiloxane-co-methylphenylpolysiloxane, a 2,4,6,8-tetramethyl-2,4,6,8-tetravinylcyclotetrasiloxane, and a 1,3,5,7-tetramethylcyclotetrasiloxane.

These side-chain type polysiloxanes can be used alone or in combination of two or more.

Preferably, a straight chain side-chain type polysiloxane in which R⁸ is a methyl group; R⁹ is a hydrogen atom (that is, SiR⁹ is a hydrosilyl group) or a vinyl group; "d" is 1; "e" is an integer of 1 or more; and "h" is an integer of 2 or more is used.

An example of the second polysiloxane includes a dual-end type polysiloxane (a polysiloxane containing addable substituted groups at both ends) that is represented by the following formula (18) and contains the addable substituted groups at both ends of a molecule.

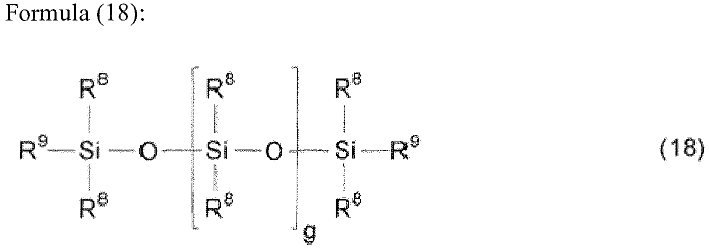

(where, in formula, R⁸ represents a monovalent hydrocarbon group selected from a saturated hydrocarbon group and an aromatic hydrocarbon group; R⁹ or SiR⁹ represents an addable substituted group; and "g" represents an integer of 1 or more. All of the R⁸s or the R⁹s may be the same or different from each other.)

An example of the monovalent hydrocarbon group represented by R⁸ includes the monovalent hydrocarbon group illustrated by R⁶ in the above-described formula (10). Preferably, methyl and phenyl are used.

As the addable substituted group represented by R⁹ or SiR⁹, for example, the above-described addable substituted group is used; preferably, the other of the substituted groups constituting one pair of addable substituted groups is used; more preferably, a hydrosilyl group and an ethylenically unsaturated group-containing group (to be specific, a vinyl group) are used; or further more preferably, a hydrosilyl group is used.

"g" is, in view of reactivity, preferably an integer of 1 or more, or more preferably an integer of 2 or more, and is preferably an integer of 100000 or less, or more preferably an integer of 10000 or less.

The number average molecular weight of the dual-end type polysiloxane is, for example, in view of stability and handling ability, 100 or more and 1000000 or less, or preferably 100 or more and 100000 or less.

Examples of the dual-end type polysiloxane include a polydimethylsiloxane containing hydrosilyl groups at both ends, a polydimethylsiloxane containing vinyl groups at both ends, a polymethylphenylsiloxane containing hydrosilyl groups at both ends, a polymethylphenylsiloxane containing vinyl groups at both ends, a polydiphenylsiloxane containing hydrosilyl groups at both ends, a polydimethylsiloxane containing vinyl groups at both ends, and a polydiphenylsiloxane containing vinyl groups at both ends.

These dual-end type polysiloxanes can be used alone or in combination of two or more.

Preferably, a polydimethylsiloxane containing hydrosilyl groups at both ends (an organohydrogenpolysiloxane) or a polydimethylsiloxane containing vinyl groups at both ends in which all of the R⁸s are methyl groups; R⁹ is a hydrogen atom (that is, SiR⁹ is a hydrosilyl group) or a vinyl group; and "g" is an integer of 2 or more and 10000 or less is used.

Of the above-described side-chain type polysiloxane and dual-end type polysiloxane, as the second polysiloxane, preferably, a dual-end type polysiloxane is used.

A commercially available product can be used as the second polysiloxane. A second polysiloxane synthesized in accordance with a known method can be also used.

In order to prepare the first silicone resin composition, the first polysiloxane and the second polysiloxane are blended. Preferably, the first polysiloxane and the second polysiloxane are blended with an addition catalyst.

The molar ratio (R⁷/SiR⁹) of the addable substituted group (one side, preferably a vinyl group (R⁷ in formula (11)) in the first polysiloxane to the addable substituted group (the other side, preferably a hydrosilyl group (SiR⁹ in formula (18)) in the second polysiloxane is, for example, 20/1 or less, preferably 10/1 or less, or more preferably 5/1 or less and is, for example, 1/20 or more, preferably 1/10 or more, or more preferably 1/5 or more.

The mixing ratio of the second polysiloxane with respect to 100 parts by mass of the total amount of the first polysiloxane and the second polysiloxane is, for example, 1 part by mass or more, preferably 50 parts by mass or more, or more preferably, 80 parts by mass or more, and is, for example, 99.99 parts by mass or less, preferably 99.9 parts by mass or less, or more preferably 99.5 parts by mass or less.

The addition catalyst is not particularly limited as long as it is a catalyst that promotes addition of the addable substituted group in the first polysiloxane with the addable substituted group in the first polysiloxane, to be specific, addition in the above-described formulas (6) to (9). Preferably, in view of promoting condensation by an active energy ray, a photocatalyst having active properties with respect to the active energy ray is used.

An example of the photocatalyst includes a hydrosilylation catalyst.

The hydrosilylation catalyst promotes a hydrosilylation addition reaction of a hydrosilyl group with an alkenyl group. An example of the hydrosilylation catalyst includes a transition element catalyst. To be specific, examples thereof include a platinum-based catalyst; a chromium-based catalyst (hexacarbonyl chromium (Cr(CO)₆ and the like); an iron-based catalyst (carbonyltriphenylphosphine iron (Fe(CO)PPh₃ and the like), tricarbonylbisphenylphosphine iron (trans-Fe(CO)₃(PPh₃)₂), polymer-substrate-(aryl-diphenylphosphine)5-n[carbonyl iron] (polymer substrate-(Ar-PPh₂)₅-n[Fe(CO)ₙ]), pentacarbonyl iron (Fe(CO)₅), and the like); a cobalt-based catalyst (tricarbonyltriethylsilylcobalt (Et₃SiCo(CO)₃), tetracarbonyltriphenylsilylcobalt (Ph₃SiCo(CO)₄), octacarbonylcobalt (Co₂(CO)₈), and the like); a molybdenum-based catalyst (hexacarbonylmolybdenum (Mo(CO)₆ and the like); a palladium-based catalyst; and a rhodium-based catalyst.

As the hydrosilylation catalyst, preferably, a platinum-based catalyst is used. Examples thereof include inorganic platinum such as platinum black, platinum chloride, and chloroplatinic acid and a platinum complex such as a platinum olefin complex, a platinum carbonyl complex, a platinum cyclopentadienyl complex, and a platinum acetylacetonate complex.

Preferably, in view of reactivity, a platinum complex is used, or more preferably, a platinum cyclopentadienyl complex and a platinum acetylacetonate complex are used.

Examples of the platinum cyclopentadienyl complex include trimethyl (methylcyclopentadienyl) platinum (IV) and a trimethyl (cyclopentadienyl) platinum (IV) complex.

An example of the platinum acetylacetonate complex includes 2,4-pentanedionato platinum (II) (platinum (II) acetylacetonate).

An example of the transition element catalyst can also include one described in the following document.

Document: ISSN 1070-3632, Russian Journal of General Chemistry, 2011, Vol.81, No.7, pp. 1480 to 1492, "Hydrosilylation on Photoactivated Catalysts", D.A. de Vekki

These addition catalysts can be used alone or in combination.

A commercially available product can be used as the addition catalyst. An addition catalyst synthesized in accordance with a known method can be also used.

The addition catalyst can be, for example, solved in a solvent to be prepared as an addition catalyst solution. The concentration of the addition catalyst in the addition catalyst solution is, for example, 1 mass % or more and 99 mass % or less. When the addition catalyst is a transition element catalyst, the concentration of the transition element is adjusted to be, for example, 0.1 mass % or more and 50 mass % or less.

The mixing ratio of the addition catalyst with respect to 100 parts by mass of the total of the first silicone resin composition is, for example, 1.0 × 10⁻¹¹ parts by mass or more, or preferably, 1.0 × 10⁻⁹ parts by mass or more, and is, for example, 0.5 parts by mass or less, or preferably 0.1 parts by mass or less.

The addition catalyst can be also used in combination with a photoassistance agent such as a photoactive agent, a photoacid generator, and a photobase generator with an appropriate amount as required.

Each of the components containing the first polysiloxane and the second polysiloxane is blended at the above-described mixing proportion to be stirred and mixed, so that the first silicone resin composition can be obtained.

The first silicone resin composition contains a part of the second silicon compound that remains in the preparation of the first polysiloxane.

The first silicone resin composition obtained as described above is, for example, in a liquid state, or preferably, in an oil state (in a viscous liquid state). The viscosity thereof under conditions of 25°C and one pressure is, for example, 100 mPa·s or more, or preferably 1000 mPa·s or more, and is, for example, 100000 mPa_{·}s or less, or preferably 50000 mPa·s or less. The viscosity thereof is measured under the conditions of one pressure using a rheometer. The viscosity is measured by adjusting a temperature of the first silicone resin composition to 25°C and using an E-type cone at a number of revolutions of 99 s⁻¹.

To be specific, in order to obtain the first silicone resin composition, first, the polydimethylsiloxane containing silanol groups at both ends, the vinyltrimethoxysilane, and di(2-ethylhexanoate)tin (II) (the condensation catalyst) are blended to prepare the first polysiloxane in an oil state. Thereafter, the polydimethylsiloxane containing hydrosilyl groups at both ends (the second polysiloxane) and a solution of the trimethyl (methylcyclopentadienyl) platinum (IV) or the platinum (II) acetylacetonate (the addition catalyst) are blended thereto.

Alternatively, first, the polydimethylsiloxane containing silanol groups at both ends, the vinyltrimethoxysilane, and di(2-ethylhexanoate)tin (II) (the condensation catalyst) are blended to prepare the first polysiloxane in an oil state. Thereafter, the polydimethylsiloxane containing hydrosilyl groups at both ends (the second polysiloxane) and a solution of the trimethyl (methylcyclopentadienyl) platinum (IV) complex or the platinum (II) acetylacetonate (the addition catalyst) are blended thereto.

### [Second Silicone Resin Composition]

The second silicone resin composition contains a third polysiloxane containing at least one pair of condensable substituted groups that is capable of condensation by heating and at least one pair of addable substituted groups that is capable of addition by an active energy ray.

An example of the one pair of condensable substituted groups includes the same one pair of condensable substituted groups as that in the first polysiloxane in the first silicone resin composition. The one pair of condensable substituted groups is replaced with the end and the middle of the main chain and/or a side chain in the third polysiloxane.

An example of the one pair of addable substituted groups includes the same one pair of addable substituted groups as that in the first and the second polysiloxanes in the first silicone resin composition. The one pair of addable substituted groups is replaced with the end and the middle of the main chain and/or a side chain in the third polysiloxane.

The third polysiloxane is represented by, for example, the following formula (19).

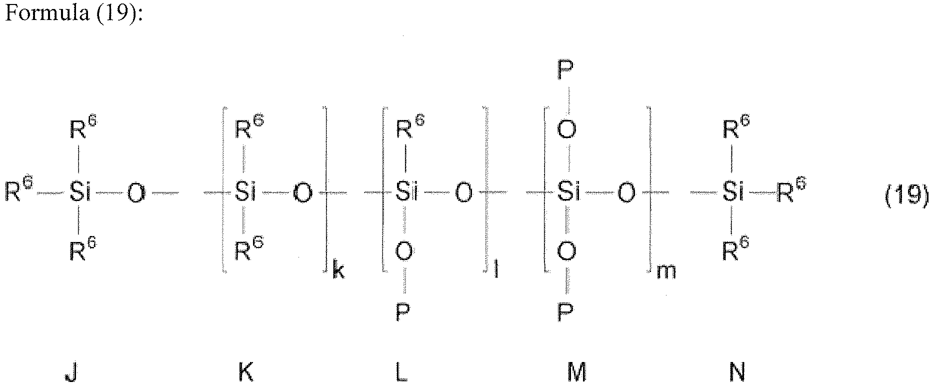

(where, in formula, R⁶ represents a monovalent hydrocarbon group selected from a saturated hydrocarbon group and an aromatic hydrocarbon group; a condensable substituted group; and/or an addable substituted group. J to N represent a constituent unit, J and N represent an end unit, and K to M represent a repeating unit. P represents a constituent unit of K to M. "k" + "1" + "m" is an integer of 1 or more. R⁶ contains at least one pair of condensable substituted groups and at least one pair of addable substituted groups.)

Examples of the monovalent hydrocarbon group, the condensable substituted group, and the addable substituted group represented by R⁶ include the monovalent hydrocarbon group, the condensable substituted group, and the addable substituted group illustrated in the above-described formula (10), respectively.

"k" + "1" + "m" is, in view of stability and handling ability, preferably an integer of 1 or more and 100000 or less, or more preferably an integer of 1 or more and 10000 or less.

"k" is, for example, an integer of 0 or more, or preferably an integer of 1 or more, and is, for example, an integer of 100000 or less, or preferably an integer of 10000 or less.

"1" is, for example, an integer of 0 or more and 100000 or less, or preferably an integer of 0 or more and 10000 or less.

"m" is, for example, an integer of 0 or more and 100000 or less, or preferably an integer of 0 or more and 10000 or less.

The number average molecular weight of the third polysiloxane is, for example, 100 or more, or preferably 200 or more, and is, for example, 1000000 or less, or preferably 100000 or less.

A commercially available product can be used as the third polysiloxane. A third polysiloxane synthesized in accordance with a known method can be also used.

The content ratio of the third polysiloxane with respect to the second silicone resin composition is, for example, 60 mass % or more, or preferably 90 mass % or more, and is, for example, 100 mass % or less.

In order to obtain a silicone semi-cured material from the second silicone resin composition, under the same conditions as those of the first silicone resin composition, the third polysiloxane is heated with the condensation catalyst and thereafter, the addition catalyst is added thereto.

### [Phosphor]

The phosphor has a wavelength conversion function and examples thereof include a yellow phosphor that is capable of converting blue light into yellow light and a red phosphor that is capable of converting blue light into red light.

Examples of the yellow phosphor include a garnet type phosphor having a garnet type crystal structure such as Y₃Al₅O₁₂:Ce (YAG (yttrium aluminum garnet):Ce) and Tb₃Al₃O₁₂:Ce (TAG (terbium aluminum garnet):Ce) and an oxynitride phosphor such as Ca-α-SiAlON.

An example of the red phosphor includes a nitride phosphor such as CaAlSiN₃:Eu and CaSiN₂:Eu.

Preferably, a yellow phosphor is used.

Examples of a shape of the phosphor include a sphere shape, a plate shape, and a needle shape. Preferably, in view of fluidity, a sphere shape is used.

The average value of the maximum length (in the case of a sphere shape, the average particle size) of the phosphor is, for example, 0.1 µm or more, or preferably 1 µm or more, and is, for example, 200 µm or less, or preferably 100 µm or less.

The mixing ratio of the phosphor with respect to 100 parts by mass of the active energy ray curable resin is, for example, 0.1 parts by mass or more, or preferably 0.5 parts by mass or more, and is, for example, 80 parts by mass or less, or preferably 50 parts by mass or less.

### [Filler]

Furthermore, the phosphor resin composition can also contain a filler.

Examples of the filler include organic microparticles such as silicone particles and inorganic microparticles such as silica, talc, alumina, aluminum nitride, and silicon nitride. The mixing ratio of the filler with respect to 100 parts by mass of the active energy ray curable resin is, for example, 0.1 parts by mass or more, or preferably 0.5 parts by mass or more, and is, for example, 70 parts by mass or less, or preferably 50 parts by mass or less.

### [Fabrication of Phosphor Sheet 5]

In order to fabricate the phosphor sheet 5, a first silicone resin composition or a second silicone resin composition in an A-stage state and a phosphor, and a filler, which is blended as required, are blended. The obtained mixture is applied to the surface of a release sheet 13 to be thereafter heated, so that the phosphor resin composition is prepared into a sheet shape. In the preparation of the first silicone resin composition or the second silicone resin composition in an A-stage state, the phosphor and the filler, which is blended as required, can be added at any timing of blending of the components or before, during, or after the reaction.

Examples of the release sheet 13 include a polymer film such as a polyethylene film and a polyester film (PET or the like), a ceramic sheet, and a metal foil. Preferably, a polymer film is used. The surface of the release sheet 13 can be also subjected to release treatment such as fluorine treatment.

In the application of the mixture, an application method such as a casting, a spin coating, or a roll coating is used.

The heating conditions are as follows: a heating temperature of, for example, 40°C or more, or preferably 60°C or more, and of, for example, 180°C or less, or preferably 150°C or less and a heating duration of, for example, 0.1 minutes or more, and of, for example, 180 minutes or less, or preferably 60 minutes or less.

When the heating conditions are within the above-described range, a low molecular weight component (for example, a solvent including water or the like) is surely removed to terminate condensation, so that the first silicone resin composition or the second silicone resin composition can be brought into a semi-cured state (a B-stage state).

When the mixture is prepared from the first silicone resin composition, at least one pair of condensable substituted groups contained in the first polysiloxane is subjected to condensation by the above-described heating. In this way, when the condensable substituted group in the first silicon compound is an alkoxy group and the condensable substituted group in the second silicon compound is a hydroxyl group, as shown in the following formula (20), the molecular weight of the first polysiloxane is increased, so that the first silicone resin composition is gelated. That is, the first silicone resin composition is brought into a semi-cured state (a B-stage state), so that a silicone semi-cured material is obtained.

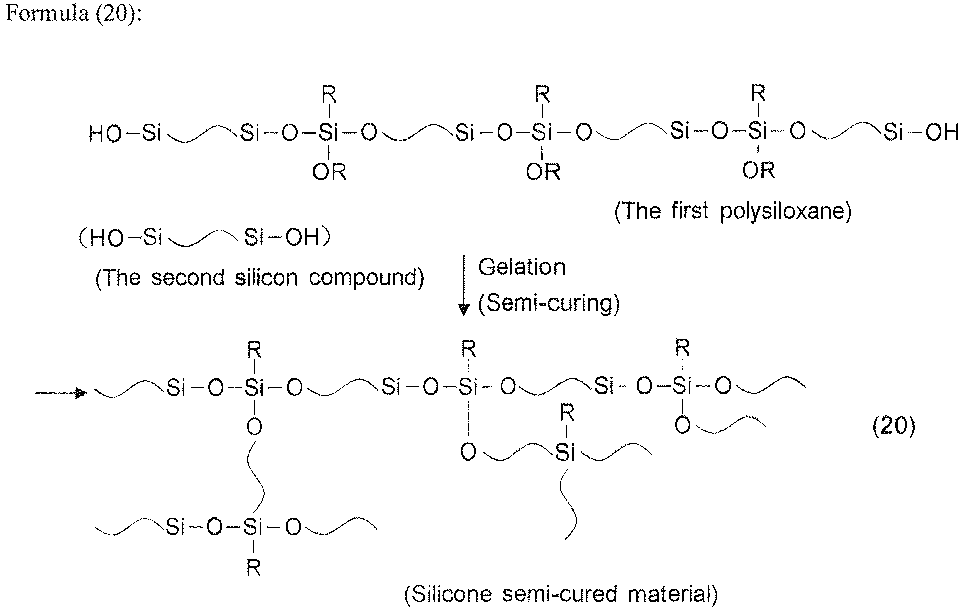

When the mixture is prepared from the second silicone resin composition, at least one pair of condensable substituted groups contained in the third polysiloxane is subjected to condensation by the above-described heating. In this way, the molecular weight of the third polysiloxane is increased, so that the second silicone resin composition is gelated. That is, the second silicone resin composition is brought into a semi-cured state (a B-stage state), so that a silicone semi-cured material is obtained.

In this way, the phosphor sheet 5 formed from the phosphor resin composition containing the silicone semi-cured material and the phosphor (and the filler blended as required) is obtained.

The phosphor sheet 5 has a compressive elastic modulus at 23°C of, for example, 0.01 MPa or more, or preferably 0.04 MPa or more, and of, for example, 1.0 MPa or less.

When the compressive elastic modulus of the phosphor sheet 5 is not more than the above-described upper limit, sufficient flexibility can be secured. On the other hand, when the compressive elastic modulus of the phosphor sheet 5 is not less than the above-described lower limit, the LEDs 4 can be embedded.

The phosphor sheet 5 has a light transmittance at the wavelength of 400 nm or less of, for example, 50 % or more, or preferably 60 % or more.

When the light transmittance of the phosphor sheet 5 is not less than the above-described lower limit, the light transmission properties can be surely secured and an LED device 15 (described later) having excellent brightness can be obtained.

The thickness of the phosphor sheet 5 is, for example, 10 µm or more, or preferably 100 µm or more, and is, for example, 5000 µm or less, or preferably 2000 µm or less.

In this way, as shown by the upper portion in FIG. 1 (a), the phosphor sheet 5 laminated on the release sheet 13 is fabricated (prepared).

Thereafter, the fabricated phosphor sheet 5 is disposed on the upper surface of the support sheet 12 so as to embed the LEDs 4 (an embedding step). That is, the phosphor sheet 5 is disposed on the support sheet 12 so as to cover the upper surfaces and the side surfaces of the LEDs 4.

To be specific, as shown by arrows in FIG. 1 (a), and in FIG. 1 (b), the phosphor sheet 5 laminated on the release sheet 13 is compressively bonded toward the support sheet 12.

That is, in the sheet disposing step, the embedding step in which the LEDs 4 are embedded by the phosphor sheet 5 is performed.

Thereafter, as shown by phantom line in FIG. 1 (b), the release sheet 13 is peeled from the phosphor sheet 5 as required.

### <Encapsulating Step>

After the sheet disposing step, as shown by the arrow in FIG. 1 (c), an active energy ray is applied to the phosphor sheet 5 in the encapsulating step.

Examples of the active energy ray include an ultraviolet ray and an electron beam. An example of the active energy ray also includes an active energy ray having a spectral distribution in a wavelength region of, for example, 180 nm or more, or preferably 200 nm or more, and of, for example, 460 nm or less, or preferably 400 nm or less.

In the application of the active energy ray, an application device is used. Examples thereof include a chemical lamp, an excimer laser, a black light, a mercury arc, a carbon arc, a low pressure mercury lamp, a medium pressure mercury lamp, a high pressure mercury lamp, an extra-high pressure mercury lamp, and a metal halide lamp. Also, an example thereof includes an application device capable of generating an active energy ray that is in the longer wavelength side or in the shorter wavelength side than in the above-described wavelength region.

The amount of irradiation is, for example, 0.001 J/cm² or more, and is, for example, 100 J/cm² or less, or preferably 10 J/cm² or less.

The irradiation duration is, for example, 10 minutes or less, or preferably 1 minute or less, and is, for example, 5 seconds or more.

The active energy ray is applied from the upper side and/or the lower side toward the phosphor sheet 5. Preferably, as shown by the arrow in FIG. 1 (c), the active energy ray is applied from the upper side toward the phosphor sheet 5.

In the application of the active energy ray toward the phosphor sheet 5, when the support sheet 12 is an active energy ray irradiation release sheet, the active energy ray irradiation release sheet and the irradiation conditions are selected so as not to reduce the pressure-sensitive adhesive force of the support sheet 12 by application of the active energy ray to the phosphor sheet 5.

Along with the above-described application of the active energy ray, heating can be also performed.

The timing of the heating may be at the same time with the application of the active energy ray, or before or after the application of the active energy ray. Preferably, the heating is performed after the application of the active energy ray.

The heating conditions are as follows: a temperature of, for example, 50°C or more, or preferably 100°C or more, and of, for example, 250°C or less, or preferably 200°C or less, and a heating duration of, for example, 0.1 minutes or more, and of, for example, 1440 minutes or less, or preferably 180 minutes or less.

The phosphor sheet 5 is completely cured (subjected to final curing) by the above-described application of the active energy ray (and heating performed as required) to be brought into a C-stage state.

To be specific, when the silicone semi-cured material is prepared from the first silicone resin composition, as shown by the following formula (21), in a case where the addable substituted group in the first polysiloxane is a vinyl group and the addable substituted group in the second polysiloxane is a hydrosilyl group, they are subjected to addition (hydrosilylation addition) by application of the active energy ray (and heating performed as required).

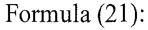

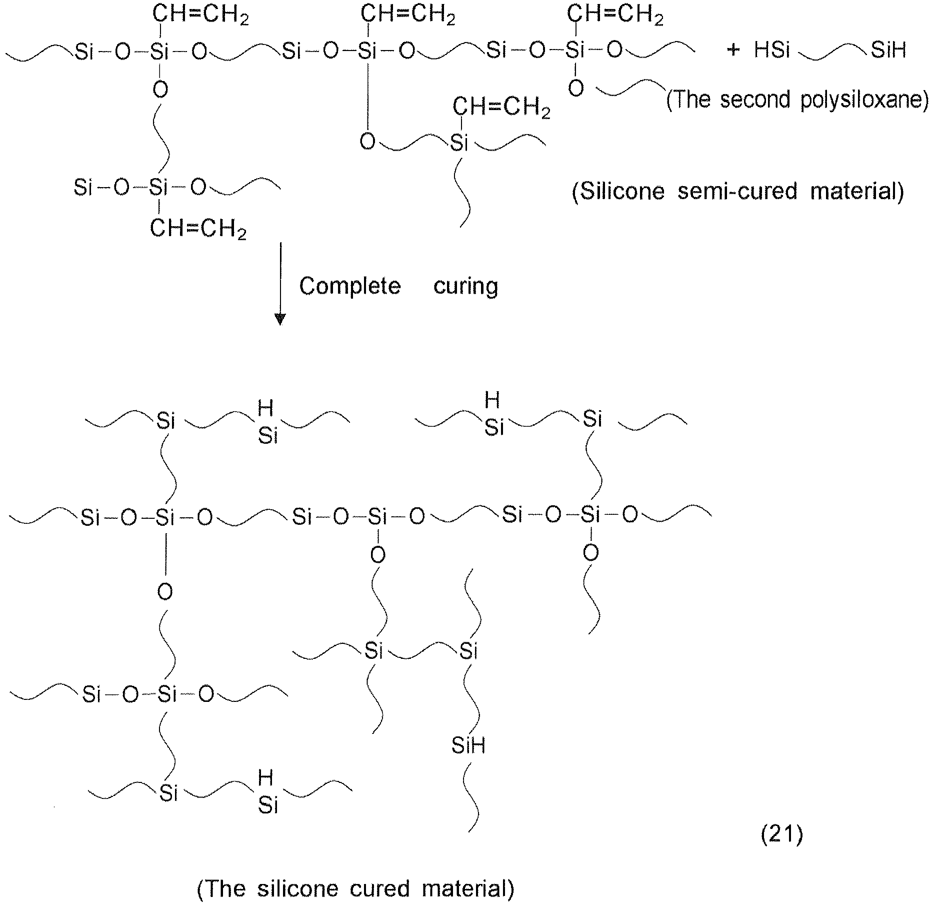

Alternatively, when the silicone semi-cured material is prepared from the second silicone resin composition, in a case where the addable substituted group in the third polysiloxane is a vinyl group and a hydrosilyl group, they are subjected to addition (hydrosilylation addition) by application of the active energy ray (and heating performed as required).

In this way, the silicone semi-cured material is completely cured. That is, the phosphor sheet 5 is completely cured (brought into a C-stage state).

The degree of progress of the addition in the complete curing can be checked with the peak strength derived from the addable substituted group with, for example, a solid NMR measurement.

The phosphor sheet 5 that is brought into a C-stage state (completely cured) has flexibility. To be specific, the phosphor sheet 5 that is brought into a C-stage state (completely cured) has a compressive elastic modulus at 23°C of, for example, 0.5 MPa or more, or preferably 1.0 MPa or more, and of, for example, 100 MPa or less, or preferably 10 MPa or less.

When the compressive elastic modulus of the phosphor sheet 5 is not more than the above-described upper limit, the flexibility can be surely secured and in the cutting step (ref: dashed lines in FIG. 1 (d)) to be described next, for example, the phosphor sheet 5 can be cut using a relatively cheap cutting device (described later). When the compressive elastic modulus of the phosphor sheet 5 is not less than the above-described lower limit, the shape thereof after being cut can be retained.

In this way, the side surfaces and the upper surfaces of the LEDs 4, and a portion of the upper surface of the support sheet 12 that is exposed from the LEDs 4 are covered with the phosphor sheet 5 in close contact with each other. That is, the LEDs 4 are encapsulated by the phosphor sheet 5 in a C-stage state.

### <Cutting Step>

After the sheet disposing step, as shown by the dashed lines in FIG. 1 (d), in the cutting step, the flexible phosphor sheet 5 around the LEDs 4 is cut along the thickness direction. The phosphor sheet 5 is, for example, cut into a generally rectangular shape in plane view that surrounds each of the LEDs 4.

In order to cut the phosphor sheet 5, for example, a dicing device using a disc-shaped dicing saw (dicing blade) 31, a cutting device using a cutter, a laser irradiation device, or the like is used.

In the cutting of the phosphor sheet 5, for example, the phosphor sheet 5 is cut from the upper surface toward the lower surface so that cuts 8 fail to pass through the support sheet 12.

By the cutting step, the phosphor sheet-covered LEDs 10, each of which includes the LED 4 and the phosphor sheet 5 that covers the surfaces (the upper surface and the side surfaces) of the LED 4, are obtained in a state of being in close contact with the support sheet 12.

### <LED Peeling Step>

After the cutting step, as shown in FIG. 1 (e), the support sheet 12 is stretched in the plane direction and each of the phosphor sheet-covered LEDs 10 is peeled from the support sheet 12.

To be specific, first, as shown by the arrows in FIG. 1 (d), the support sheet 12 is stretched outwardly in the plane direction. In this way, as shown in FIG. 1 (e), in a state where the phosphor sheet-covered LEDs 10 are in close contact with the support sheet 12, the tensile stress is concentrated in the cuts 8; thus, the cuts 8 expand; and the LEDs 4 are separated from each other, so that gaps 19 are formed. Each of the gaps 19 is formed into a generally grid shape in plane view so as to separate the LEDs 4.

Thereafter, each of the phosphor sheet-covered LEDs 10 is peeled from the upper surface of the support sheet 12.

To be specific, as shown in FIG. 1 (e'), for example, each of the phosphor sheet-covered LEDs 10 is peeled from the support sheet 12 with a pick-up device 17 that is provided with a pressing member 14 such as a needle and an absorbing member 16 such as a collet. In the pick-up device 17, the pressing member 14 presses (pushes up) the support sheet 12 corresponding to the phosphor sheet-covered LED 10 that is intended to be peeled off from the lower side thereof. In this way, the phosphor sheet-covered LED 10 that is intended to be peeled off is pushed up upwardly, and the pushed-up phosphor sheet-covered LED 10 is peeled from the support sheet 12, while being absorbed by the absorbing member 16 such as a collet.

When the support sheet 12 is stretched in the plane direction, the gap 19 is formed between the phosphor sheet-covered LED 10 that is intended to be peeled off and the phosphor sheet-covered LED 10 that is adjacent thereto. Thus, it can be prevented that when the absorbing member 16 is brought into contact with the phosphor sheet-covered LED 10 that is intended to be peeled off, the absorbing member 16 comes in contact with the phosphor sheet-covered LED 10 that is adjacent thereto to cause a damage to the phosphor sheet-covered LED 10.

When the above-described support sheet 12 is a thermal release sheet, instead of the stretching of the support sheet 12 described above or in addition to the stretching of the support sheet 12, the support sheet 12 can be also heated at, for example, 50°C or more, or preferably 70°C or more, and at, for example, 200°C or less, or preferably 150°C or less.

When the above-described support sheet 12 is an active energy ray irradiation release sheet, instead of the stretching of the support sheet 12 described above or in addition to the stretching of the support sheet 12, an active energy ray can be also applied to the support sheet 12.

The pressure-sensitive adhesive force of the support sheet 12 is reduced by those treatments, so that each of the phosphor sheet-covered LEDs 10 can be further easily peeled from the support sheet 12.

In this way, as shown in FIG. 1 (e), each of the phosphor sheet-covered LEDs 10 that is peeled from the support sheet 12 is obtained.

### <Mounting Step>

After the peeling step, after the phosphor sheet-covered LED 10 is selected in accordance with emission wavelength and luminous efficiency, as shown in FIG. 1 (f), the selected phosphor sheet-covered LED 10 is mounted on a board 9. In this way, the LED device 15 is obtained.

That is, the phosphor sheet-covered LED 10 is disposed in opposed relation to the board 9 so that a bump (not shown) in the LED 4 is opposed to a terminal (not shown) provided on the upper surface of the board 9. To be specific, the LED 4 in the phosphor sheet-covered LED 10 is flip-chip mounted on the board 9.

In this way, the LED device 15 including the board 9 and the phosphor sheet-covered LED 10 that is mounted on the board 9 is obtained.

Thereafter, as shown by the phantom line in FIG. 1 (f), an encapsulating protective layer 20 that encapsulates the phosphor sheet-covered LED 10 is provided in the LED device 15 as required. In this way, reliability of the LED device 15 can be improved.

In the method for producing the phosphor sheet-covered LED 10, the phosphor sheet 5 that is formed from a phosphor resin composition containing an active energy ray curable resin, which is capable of being cured by application of an active energy ray, and a phosphor is laminated on the upper surface of the support sheet 12 so as to cover the LEDs 4. Thereafter, the active energy ray is applied to the phosphor sheet 5 and the LEDs 4 are encapsulated by the phosphor sheet 5. Thus, a damage to the support sheet 12 is suppressed and the LEDs 4 are encapsulated, so that the phosphor is capable of being uniformly dispersed around the LEDs 4.

That is, the phosphor sheet 5 is cured by application of the active energy ray thereto without heating the phosphor sheet 5 or by reducing the heating thereof, so that the LEDs 4 can be encapsulated. Thus, the support sheet 12 that supports the phosphor sheet 5 is not required to have heat resistance, that is, the support sheet 12 having low heat resistance can be used.

Additionally, when the phosphor sheet 5 is completely cured, the irradiation duration for applying an active energy ray can be set to be short, compared to a case where the phosphor sheet 5 is completely cured by heating only.

Also, by cutting the phosphor sheet 5 corresponding to each of the LEDs 4, the phosphor sheet-covered LEDs 10, each of which includes the LED 4 and the phosphor sheet 5 that covers the surface of the LED 4, are obtained. Thereafter, each of the phosphor sheet-covered LEDs 10 is peeled from the support sheet 12. Thus, the phosphor sheet 5 supported by the support sheet 12 in which a damage is suppressed is cut with excellent size stability, so that the phosphor sheet-covered LED 10 having excellent size stability can be obtained.

When the phosphor sheet 5 is cut while being supported by the support sheet 12 in the cutting step and thereafter, the support sheet 12 is heated in the peeling step, the support sheet 12 that supports the phosphor sheet 5 in the cutting step and completes its role is heated and then, each of the phosphor sheet-covered LEDs 10 is peeled off. In this way, the phosphor sheet-covered LED 10 having excellent size stability can be efficiently obtained.

Consequently, the phosphor sheet-covered LED 10 has excellent size stability.

The LED device 15 includes the phosphor sheet-covered LED 10 having excellent size stability, so that it has excellent reliability and thus, its luminous efficiency is improved.

### <Modified Example>

In the first embodiment, the support sheet of the present invention is formed of one layer of the support sheet 12. Alternatively, for example, though not shown, the support sheet can be also formed of two layers of a hard support board that is incapable of stretching in the plane direction and a pressure-sensitive adhesive layer that is laminated on (at one side in the thickness direction of) the support board.

Examples of a hard material for forming the support board include an oxide such as a silicon oxide (silica or the like) and a metal such as stainless steel. The thickness of the support board is, for example, 0.1 mm or more, or preferably 0.3 mm or more, and is, for example, 5 mm or less, or preferably 2 mm or less.

The pressure-sensitive adhesive layer is formed on the entire upper surface of the support board. An example of a pressure-sensitive adhesive material for forming the pressure-sensitive adhesive layer includes a pressure-sensitive adhesive such as an acrylic pressure-sensitive adhesive. The thickness of the pressure-sensitive adhesive layer is, for example, 0.1 mm or more, or preferably 0.2 mm or more, and is, for example, 1 mm or less, or preferably 0.5 mm or less.

Preferably, as shown by the upper portion in FIG. 1 (a), one layer of the support sheet 12 that is capable of stretching in the plane direction is used as a support sheet of the present invention.

According to this, in the LED peeling step shown in FIG. 1 (e), the support sheet 12 is stretched in the plane direction and each of the phosphor sheet-covered LEDs 10 is peeled from the support sheet 12. Thus, as shown in FIG. 1 (e'), the phosphor sheet-covered LED 10 can be easily and surely peeled from the support sheet 12 using the above-described pick-up device 17.

A hard support board is not provided in the support sheet 12, so that as referred in FIG. 1 (e'), the support sheet 12 and the corresponding phosphor sheet-covered LED 10 can be pushed up from the lower side by the pressing member 14 in the pick-up device 17.

Additionally, a hard support board is not required to be laminated on the pressure-sensitive adhesive layer, so that the production process can be simplified.

### <Second Embodiment>

FIG. 2 shows process drawings for illustrating a second embodiment of a method for producing a phosphor layer-covered LED of the present invention. FIG. 3 shows a plan view of the phosphor sheet-embedded LEDs shown in FIG. 2 (d). FIG. 4 shows process drawings for illustrating a method for producing the embedding-reflector sheet shown in FIG. 2 (a).

In the second embodiment, the same reference numerals are provided for members and steps corresponding to each of those in the first embodiment, and their detailed description is omitted.

In the first embodiment, as shown in FIG. 1 (a), the phosphor sheet 5 in which a phosphor is uniformly (uniformly at least in the plane direction) dispersed is illustrated as one example of a phosphor layer of the present invention. Alternatively, for example, as shown in FIGS. 2 (a) and 3, an embedding-reflector sheet 24 that includes embedding portions 33 containing a phosphor as cover portions and a reflector portion 34 surrounding the embedding portions 33 can be also illustrated as an encapsulating sheet.

As shown in FIG. 3, a plurality of the embedding portions 33 are provided at spaced intervals to each other as portions that embed a plurality of the LEDs 4 in the embedding-reflector sheet 24. Each of the embedding portions 33 is formed into a generally circular shape in plane view. To be specific, as shown in FIG. 2 (a), each of the embedding portions 33 is formed into a generally conical trapezoidal shape in which its width is gradually reduced toward the lower side.

The diameter (the maximum length) of the lower end portion of each of the embedding portions 33 is larger than the maximum length in the plane direction of each of the LEDs 4. To be specific, the diameter (the maximum length) of the lower end portion thereof with respect to the maximum length in the plane direction of each of the LEDs 4 is, for example, 200 % or more, preferably 300 % or more, or more preferably 500 % or more, and is, for example, 3000 % or less. To be more specific, the diameter (the maximum length) of the lower end portion of each of the embedding portions 33 is, for example, 5 mm or more, or preferably 7 mm or more, and is, for example, 300 mm or less, or preferably 200 mm or less.

The diameter (the maximum length) of the upper end portion of each of the embedding portions 33 is larger than the diameter (the maximum length) of the lower end portion thereof. To be specific, the diameter (the maximum length) of the upper end portion thereof is, for example, 7 mm or more, or preferably 10 mm or more, and is, for example, 400 mm or less, or preferably 250 mm or less.

The gap between the embedding portions 33 (the minimum gap, to be specific, the gap between the upper end portions of the embedding portions 33) is, for example, 20 mm or more, or preferably 50 mm or more, and is, for example, 1000 mm or less, or preferably 200 mm or less.

The embedding portions 33 are formed from the above-described phosphor resin composition. When the phosphor resin composition contains a curable resin, the embedding portions 33 are formed in a B-stage state.

As shown in FIG. 3, the reflector portion 34 is continuous at the circumference end portion of the embedding-reflector sheet 24 and is disposed between the embedding portions 33. The reflector portion 34 is formed into a generally grid shape in plane view surrounding each of the embedding portions 33.

The reflector portion 34 is formed from a reflecting resin composition containing a light reflecting component to be described later.

Next, a method for producing the embedding-reflector sheet 24 is described with reference to FIGS. 3 and 4.

In this method, first, as shown in FIG. 4 (a), a pressing device 35 is prepared.

The pressing device 35 is provided with a support board 36 and a die 37 that is disposed in opposed relation to the upper side of the support board 36.

The support board 36 is, for example, formed of a metal such as stainless steel into a generally rectangular flat plate shape.

The die 37 is, for example, formed of a metal such as stainless steel and integrally includes a flat plate portion 38 and extruded portions 39 that are formed to be extruded downwardly from the flat plate portion 38.

The flat plate portion 38 is formed into the same shape as that of the support board 36 in plane view.

In the die 37, a plurality of the extruded portions 39 are disposed at spaced intervals to each other in the plane direction so as to correspond to the embedding portions 33. That is, each of the extruded portions 39 is formed into a generally conical trapezoidal shape in which its width is gradually reduced from the lower surface of the flat plate portion 38 toward the lower side. To be specific, each of the extruded portions 39 is formed into a tapered shape in which its width is gradually reduced toward the lower side in front sectional view and side sectional view. That is, each of the extruded portions 39 is formed into the same shape as that of each of the embedding portions 33.

As shown in FIG. 4 (a), a spacer 40 is provided on the upper surface of the circumference end portion of the support board 36. The spacer 40 is, for example, formed of a metal such as stainless steel and is disposed so as to surround a plurality of the embedding portions 33 when projected in the thickness direction. The spacer 40 is disposed on the support board 36 so as to be included in the die 37, to be specific, to be overlapped with the circumference end portion of the flat plate portion 38, when projected in the thickness direction.

The thickness of the spacer 40 is set so as to be the total thickness of the thickness of a releasing sheet 49 to be described later and that of each of the extruded portions 39. To be specific, the thickness of the spacer 40 is, for example, 0.3 mm or more, or preferably 0.5 mm or more, and is, for example, 5 mm or less, or preferably 3 mm or less.

In the pressing device 35, the die 37 is configured to be replaceable with that having a different shape. To be specific, in the pressing device 35, the die 37 having the extruded portions 39 shown in FIG. 4 (a) is configured to be replaceable with the die 37 in a flat plate shape having no extruded portion 39 shown in FIG. 4 (c) to be described later.

As shown in FIG. 4 (a), the releasing sheet 49 is disposed at the inner side of the spacer 40 on the upper surface of the support board 36. The circumference end surfaces of the releasing sheet 49 are, on the upper surface of the support board 36, formed so as to be in contact with the inner side surfaces of the spacer 40. The thickness of the releasing sheet 49 is, for example, 10 µm or more, or preferably 30 µm or more, and is, for example, 200 µm or less, or preferably 150 µm or less.

Next, in the pressing device 35 shown in FIG. 4 (a), a reflector sheet 42 is disposed on the upper surface of the releasing sheet 49.

In order to dispose the reflector sheet 42 on the upper surface of the releasing sheet 49, for example, the following method is used: that is, a laminating method in which the reflector sheet 42 formed from a reflecting resin composition is laminated on the upper surface of the releasing sheet 49 or an application method in which a liquid reflecting resin composition is applied to the upper surface of the releasing sheet 49.

The reflecting resin composition contains, for example, a resin and a light reflecting component.

An example of the resin includes a thermosetting resin such as a thermosetting silicone resin, an epoxy resin, a thermosetting polyimide resin, a phenol resin, a urea resin, a melamine resin, an unsaturated polyester resin, a diallyl phthalate resin, and a thermosetting urethane resin. Preferably, a thermosetting silicone resin and an epoxy resin are used.

The light reflecting component is, for example, a white compound. To be specific, an example of the white compound includes a white pigment.

An example of the white pigment includes a white inorganic pigment. Examples of the white inorganic pigment include an oxide such as a titanium oxide, a zinc oxide, and a zirconium oxide; a carbonate such as white lead (lead carbonate) and calcium carbonate; and a clay mineral such as kaolin (kaolinite).

As the white inorganic pigment, preferably, an oxide is used, or more preferably, a titanium oxide is used.

To be specific, the titanium oxide is TiO₂ (titanium oxide (IV), titanium dioxide).

A crystal structure of the titanium oxide is not particularly limited. Examples of the crystal structure thereof include a rutile type, a brookite type (pyromelane), and an anatase type (octahedrite). Preferably, a rutile type is used.

A crystal system of the titanium oxide is not particularly limited. Examples of the crystal system thereof include a tetragonal system and an orthorhombic system. Preferably, a tetragonal system is used.

When the crystal structure and the crystal system of the titanium oxide are the rutile type and the tetragonal system, respectively, it is possible to effectively prevent a reduction of the reflectivity with respect to light (to be specific, visible light, among all, the light around the wavelength of 450 nm) even in a case where the reflector portion 34 is exposed to a high temperature for a long time.

The light reflecting component is in the form of a particle. The shape thereof is not limited and examples of the shape thereof include a sphere shape, a plate shape, and a needle shape. The average value of the maximum length (in the case of a sphere shape, the average particle size) of the light reflecting component is, for example, 1 nm or more and 1000 nm or less. The average value of the maximum length is measured using a laser diffraction scattering particle size analyzer.

The mixing ratio of the light reflecting component with respect to 100 parts by mass of the resin is, for example, 30 parts by mass or more, or preferably 50 parts by mass or more, and is, for example, 200 parts by mass or less, or preferably 100 parts by mass or less.

The above-described light reflecting component is uniformly dispersed and mixed in the resin.

Also, the above-described filler can be further added to the reflecting resin composition. That is, the filler can be used in combination with the light reflecting component (to be specific, a white pigment).

An example of the filler includes a known filler excluding the above-described white pigment. To be specific, examples of the filler include organic microparticles such as silicone particles and inorganic microparticles such as silica, talc, alumina, aluminum nitride, and silicon nitride.

The addition ratio of the filler is adjusted so that the total amount of the filler and the light reflecting component with respect to 100 parts by mass of the resin is, for example, 400 parts by mass or more, preferably 500 parts by mass or more, or more preferably 600 parts by mass or more, and is, for example, 2500 parts by mass or less, preferably 2000 parts by mass or less, or more preferably 1600 parts by mass or less.

In the laminating method, the reflecting resin composition is prepared in an A-stage state by blending the above-described resin and light reflecting component, and the filler, which is added as required, to be uniformly mixed.

Subsequently, in the laminating method, the reflecting resin composition in an A-stage state is applied to the surface of a release sheet that is not shown by an application method such as a casting, a spin coating, or a roll coating and thereafter, the applied product is heated to be brought into a B-stage state or C-stage state. An example of the release sheet includes the same one as the above-described release sheet 13.

Alternatively, for example, the reflecting resin composition in an A-stage state is applied to the surface of a release sheet that is not shown using a screen printing or the like by the above-described application method and thereafter, the applied product is heated to form the reflector sheet 42 in a B-stage state or C-stage state.

Thereafter, the reflector sheet 42 is transferred onto the releasing sheet 49. Subsequently, the release sheet that is not shown is peeled off.

On the other hand, in the application method, the above-described reflecting resin composition in an A-stage state is applied to the upper surface of the releasing sheet 49 using a screen printing or the like and thereafter, the applied product is heated to form the reflector sheet 42 in a B-stage state.

The thickness of the reflector sheet 42 is, for example, 0.3 mm or more, or preferably 0.5 mm or more, and is, for example, 5 mm or less, or preferably 3 mm or less.

Subsequently, as shown by the arrows in FIG. 4 (a), and in FIG. 4 (b), the reflector sheet 42 is pressed by the pressing device 35.

To be specific, the die 37 is pushed down with respect to the support board 36. To be more specific, the die 37 is pushed downwardly so that the extruded portions 39 pass through the reflector sheet 42 in the thickness direction. Along with this, the circumference end portion of the flat plate portion 38 in the die 37 is brought into contact with the upper surface of the spacer 40.

In this way, as shown in FIG. 4 (b), in the reflector sheet 42, through holes 41, which pass through the reflector sheet 42 in the thickness direction and are in shapes corresponding to the extruded portions 39, are formed.

In the pushing down of the die 37, when the reflecting resin composition contains a thermosetting resin in a B-stage state, a heater (not shown) is built in the die 37 in advance and the reflector sheet 42 can be also heated by the heater. In this way, the reflecting resin composition is completely cured (is brought into a C-stage state).

The heating temperature is, for example, 80°C or more, or preferably 100°C or more, and is, for example, 200°C or less, or preferably 180°C or less.

In this way, the reflector portion 34 is formed on the releasing sheet 49.

Thereafter, as shown in FIG. 4 (c), a pressing state of the pressing device 35 is released. To be specific, the die 37 is pulled up.

Subsequently, the die 37 including the flat plate portion 38 and the extruded portions 39 is replaced with the die 37 including the flat plate portion 38 only.

Along with this, the phosphor sheet 5 is disposed on the reflector portion 34.

To be specific, the phosphor sheet 5 is disposed on the upper surface of the reflector portion 34 so as to cover the through holes 41.

To be specific, the phosphor sheet 5 in a B-stage state is disposed on the reflector portion 34. The phosphor sheet 5 is in a B-stage state, so that it can retain its flat plate shape to some extent. Thus, the phosphor sheet 5 is disposed on the upper surface of the reflector portion 34 so as to cover the through holes 41 without falling into the inside of the through holes 41.

The phosphor sheet 5 in a B-stage state is formed to be more flexible than the reflector portion 34 (to be specific, the reflector portion 34 in a C-stage state when the reflecting resin composition of the reflector sheet 42 contains a curable resin). To be specific, the reflector portion 34 is formed to have non-deformable hardness by the next pressing (ref: FIG. 4 (d)), while the phosphor sheet 5 is formed to have deformable flexibility by the next pressing.

Next, as shown in FIG. 4 (d), the phosphor sheet 5 is pressed by the pressing device 35. To be specific, the die 37 made of the flat plate portion 38 is pushed down toward the support board 36. Along with this, the circumference end portion of the flat plate portion 38 is brought into contact with the upper surface of the spacer 40. The lower surface of the flat plate portion 38 is in contact with the upper surface of the reflector portion 34.

In this way, the relatively flexible phosphor sheet 5 is pressed from the upper side by the flat plate portion 38 to fill the through holes 41. On the other hand, the relatively hard reflector portion 34 is not deformed and houses the embedding portions 33 in the through holes 41 therein.

The phosphor sheet 5 can be also heated by a heater that is built in the flat plate portion 38.

In this way, the embedding portions 33 are formed in the through holes 41 in the reflector portion 34.

In this way, the embedding-reflector sheet 24 including the embedding portions 33 and the reflector portion 34 is obtained between the support board 36 and the die 37.

Thereafter, as shown in FIG. 4 (e), the die 37 is pulled up and subsequently, the embedding-reflector sheet 24 is peeled from the releasing sheet 49.

Next, using the embedding-reflector sheet 24 shown in FIG. 4 (e), a method for producing the phosphor sheet-covered LED 10 and the LED device 15, which has different steps from those in the above-described embodiment, is described in detail with reference to FIG. 2.

### [Sheet Disposing Step]

As shown by the upper side view in FIG. 2 (b), the embedding-reflector sheet 24 is disposed above the support sheet 12 so that each of the embedding portions 33 is formed into a tapered shape in which its width is gradually reduced toward the lower side.

That is, each of a plurality of the embedding portions 33 is disposed in opposed relation to each of a plurality of the LEDs 4. To be specific, each of the embedding portions 33 is disposed to be opposed to the center of each of the LEDs 4 and each of the LEDs 4 is also disposed at spaced intervals to the inner side of the reflector portion 34 in plane view.

Subsequently, as shown in FIG. 2 (b), the embedding-reflector sheet 24 is pressed. In this way, each of the LEDs 4 is embedded in each of the embedding portions 33 so that the upper surface and the side surfaces of the LED 4 are covered with the embedding portion 33.

### [Encapsulating Step]

As shown in FIG. 2 (c), in the encapsulating step, an active energy ray is applied to the phosphor sheet 5 to cure the phosphor sheet 5. In this way, the embedding portions 33 are completely cured. In this way, each of the LEDs 4 is encapsulated by each of the embedding portions 33.

### [Cutting Step]

As shown by the dashed lines in FIG. 2 (d), in the cutting step, the reflector portion 34 is cut along the thickness direction. As shown by the dash-dot lines in FIG. 3, for example, the phosphor sheet 5 is cut so that the reflector portion 34 is formed into a generally rectangular shape in plane view that surrounds each of the embedding portions 33.

By the cutting step, the phosphor sheet-covered LEDs 10, each of which includes one LED 4, the embedding portion 33 that embeds the LED 4, and the reflector portion 34 that is provided around the embedding portion 33, are obtained in a state of being in close contact with the support sheet 12. That is, each of the phosphor sheet-covered LEDs 10 includes the reflector portion 34. That is, the phosphor sheet-covered LED 10 is a reflector portion-including phosphor sheet-covered LED 10.

### [LED Peeling Step]

In the LED peeling step, as shown in FIG. 2 (e), each of the phosphor sheet-covered LEDs 10 each including the reflector portion 34 is peeled from the support sheet 12.

### [Mounting Step]

In the mounting step, after the phosphor sheet-covered LED 10 including the reflector portion 34 is selected in accordance with emission wavelength and luminous efficiency, as shown in FIG. 2 (f), the selected phosphor sheet-covered LED 10 is mounted on the board 9. In this way, the LED device 15 is obtained.

In this way, the LED device 15 including the board 9 and the phosphor sheet-covered LED 10 that is mounted on the board 9 and includes the reflector portion 34 is obtained.

According to the second embodiment, the embedding-reflector sheet 24 includes the embedding portion 33 that embeds the LED 4 and the reflector portion 34 that contains a light reflecting component and is formed so as to surround the embedding portion 33, so that light emitted from the LED 4 can be reflected by the reflector portion 34. Thus, the luminous efficiency of the LED device 15 can be improved.

### <Modified Example>

Also, the release sheet 13 (ref: the phantom lines in FIG. 2 (a)) is provided between the flat plate portion 38 and the phosphor sheet 5 that are shown in FIG. 4 (c) to form the embedding-reflector sheet 24 in which the release sheet 13 is laminated on the upper surface thereof. Thereafter, as shown by the phantom lines in FIG. 2 (b), the embedding-reflector sheet 24 can be also, for example, subjected to flat plate pressing with respect to a plurality of the LEDs 4 and the support sheet 12.

### <Third Embodiment>

FIG. 5 shows process drawings for illustrating a method for producing an embedding-reflector sheet used in a third embodiment of a method for producing a phosphor layer-covered LED of the present invention.

In the third embodiment, the same reference numerals are provided for members and steps corresponding to each of those in the second embodiment, and their detailed description is omitted.

In the method for producing the embedding-reflector sheet 24 in the second embodiment, as shown in FIGS. 4 (c) and 4 (d), the embedding portions 33 are formed of the phosphor sheet 5. Alternatively, for example, as shown in FIG. 5 (c), the embedding portions 33 can be also formed by potting a varnish of a phosphor resin composition into the through holes 41 without using the phosphor sheet 5.

To be specific, first, the phosphor resin composition is prepared as a varnish. To be specific, a varnish in an A-stage state is prepared from the phosphor resin composition. In this way, the phosphor resin composition in an A-stage state fills the through holes 41.

Thereafter, the phosphor resin composition in an A-stage state is brought into a B-stage state.

In the third embodiment, the same function and effect as that of the second embodiment can be achieved.

### <Fourth Embodiment>

FIG. 6 shows process drawings for illustrating a fourth embodiment of a method for producing a phosphor layer-covered LED of the present invention.

In the fourth embodiment, the same reference numerals are provided for members and steps corresponding to each of those in the second and third embodiments, and their detailed description is omitted.

In the second embodiment, as shown in FIGS. 2 (a) and 3, the lower end portion of the embedding portion 33 is formed to be larger than the LED 4 in plane view. Alternatively, for example, as shown in FIG. 6 (a), the lower end portion of the embedding portion 33 can be formed to be the same size as that of the LED 4.

### [LED Disposing Step]

Each of the embedding portions 33 is, for example, formed into a generally quadrangular pyramid trapezoidal shape in which its width is gradually reduced toward the lower side.

In order to form the embedding portions 33 shown in FIG. 6 (a), each of the extruded portions 39 referred in FIGS. 4 and 5 is formed into a generally quadrangular pyramid trapezoidal shape in which its width is gradually reduced from the lower surface of the flat plate portion 38 toward the lower side.

Also, as shown by the dash-dot lines in FIG. 6 (a), the embedding-reflector sheet 24 is disposed on the support sheet 12 including the LEDs 4 so that, when projected in the thickness direction, the lower end portion of each of the embedding portions 33 is overlapped with each of the LEDs 4, to be specific, the circumference end edge of the lower end portion of each of the embedding portions 33 is formed at the same position as the circumference end edge of each of the LEDs 4 in plane view.

In the fourth embodiment, the same function and effect as those of the second and third embodiments can be achieved.

### <Fifth Embodiment>

FIG. 7 shows process drawings for illustrating a fifth embodiment of a method for producing a phosphor layer-covered LED of the present invention. FIG. 8 shows process drawings for illustrating a method for producing the embedding-reflector sheet shown in FIG. 7 (a).

In the fifth embodiment, the same reference numerals are provided for members and steps corresponding to each of those in the second embodiment, and their detailed description is omitted.

In the second embodiment, as shown in FIG. 2 (a), each of the embedding portions 33 in the embedding-reflector sheet 24 is formed into a generally conical trapezoidal shape in which its width is gradually reduced toward the lower side. Alternatively, for example, as shown in FIG. 7 (a), each of the embedding portions 33 can be also formed into a generally column shape extending in the up-down direction (the thickness direction).

In order to form the embedding portions 33, a punching device 55 shown in FIGS. 8 (a) and 8 (b) is used.

The punching device 55 is provided with a support board 56 and a die 57 that is disposed in opposed relation to the upper side of the support board 56.

The support board 56 is, for example, formed of a metal such as stainless steel into a generally rectangular flat plate shape. Through holes 53 that pass through the support board 56 in the thickness direction are formed.

Each of the through holes 53 is formed into a generally circular shape in plane view.

The die 57 integrally includes a flat plate portion 58 and extruded portions 59 that are formed to be extruded downwardly from the flat plate portion 58.

The flat plate portion 58 is formed into the same shape as that of the flat plate portion 38 shown in FIG. 4 (a).

In the die 57, a plurality of the extruded portions 59 are disposed at spaced intervals to each other in the plane direction so as to correspond to the embedding portions 33 (ref: FIG. 8 (d)). That is, each of the extruded portions 59 is formed into the same shape and the same size as those of each of the through holes 53 in plane view, to be specific, into a generally column shape. Each of the extruded portions 59 is formed into the same shape as that of each of the embedding portions 33 (ref: FIG. 8 (d)). That is, each of the extruded portions 59 is formed into a generally rectangular shape in front sectional view and side sectional view.

In this way, the punching device 55 is configured to allow the extruded portions 59 to be capable of being inserted into the through holes 53 by the pushing down of the die 57.

The hole diameter of each of the through holes 53 and the diameter of each of the extruded portions 59 are, for example, 5 mm or more, or preferably 7 mm or more, and are, for example, 300 mm or less, or preferably 200 mm or less.

The spacer 40 is provided on the upper surface of the circumference end portion of the support board 56. The spacer 40 is, in plane view, disposed in a generally frame shape in plane view at the circumference end portion of the support board 56 so as to surround the through holes 53.

In order to form the embedding-reflector sheet 24 by the punching device 55 shown in FIGS. 8 (a) and 8 (b), first, as shown in FIG. 8 (a), the reflector sheet 42 is disposed on the support board 56. To be specific, the reflector sheet 42 is disposed on the upper surface of the support board 56 so as to cover a plurality of the through holes 53.

Next, as shown in FIG. 8 (b), the reflector sheet 42 is stamped out using the punching device 55.

To be specific, the extruded portions 59 stamp out the reflector sheet 42 by pushing down the die 57.

In this way, the through holes 41 in shapes corresponding to the extruded portions 59 are formed in the reflector sheet 42.

In this way, the reflector portion 34 is formed on the support board 56.

Next, as shown in FIG. 8 (c), the die 57 is pulled up.

Thereafter, the formed reflector portion 34 is disposed in the pressing device 35 that is provided with the support board 36 and the die 37 made of the flat plate portion 38, and includes the releasing sheet 49.

Next, the phosphor sheet 5 is disposed on the reflector portion 34.

Next, as shown by the arrows in FIG. 8 (c), and in FIG. 8 (d), the phosphor sheet 5 is pressed by the pressing device 35. In this way, the embedding portions 33 are formed in the inside of the through holes 41 in the reflector portion 34.

In this way, the embedding-reflector sheet 24 including the embedding portions 33 and the reflector portion 34 is obtained between the support board 36 and the die 37.

Thereafter, the die 37 is pulled up and subsequently, as shown in FIG. 8 (e), the embedding-reflector sheet 24 is peeled from the releasing sheet 49.

In the fifth embodiment, the same function and effect as that of the second embodiment can be achieved.

### <Sixth Embodiment>

FIG. 9 shows process drawings for illustrating a method for producing an embedding-reflector sheet used in a sixth embodiment of a method for producing a phosphor layer-covered LED of the present invention:

In the sixth embodiment, the same reference numerals are provided for members and steps corresponding to each of those in the fifth embodiment, and their detailed description is omitted.

In the method for producing the embedding-reflector sheet 24 in the fifth embodiment, as shown in FIGS. 8 (c) and 8 (d), the embedding portions 33 are formed of the phosphor sheet 5. Alternatively, for example, as shown in FIG. 9 (c), the embedding portions 33 can be also formed by potting a varnish of a phosphor resin composition into the through holes 41 without using the phosphor sheet 5.

To be specific, the reflector portion 34 shown in FIG. 9 (b) is taken out from the punching device 55 to be subsequently, as shown in FIG. 9 (c), disposed on the upper surface of the releasing sheet 49. Then, the varnish of the phosphor resin composition is potted into the through holes 41.

In the sixth embodiment, the same function and effect as that of the fifth embodiment can be achieved.

### <Seventh Embodiment>

FIG. 10 shows process drawings for illustrating a seventh embodiment of a method for producing a phosphor layer-covered LED of the present invention.

In the seventh embodiment, the same reference numerals are provided for members and steps corresponding to each of those in the fifth embodiment, and their detailed description is omitted.

In the fifth embodiment, as shown in FIG. 7 (b), the embedding portions 33 that embed the LEDs 4 are illustrated as cover portions. Alternatively, for example, as shown in FIG. 10 (c), cover portions 43 that cover the upper surfaces of the LEDs 4 can be also illustrated.

As shown in FIG. 10 (b), the cover portions 43 are provided in a cover-reflector sheet 44 so as to be surrounded by the reflector portion 34. In the cover-reflector sheet 44, each of the cover portions 43 is formed into the same shape as that of each of the embedding portions 33 shown in FIG. 7 (b) and furthermore, is formed into the same size as that of each of the LEDs 4.

As shown in FIG. 10 (b), for example, each of the cover portions 43 is disposed on the upper surface of each of the LEDs 4 so that each of the cover portions 43 is overlapped with each of the LEDs 4 when projected in the thickness direction, to be specific, the circumference end edge of each of the cover portions 43 is formed at the same position as the circumference end edge of each of the LEDs 4 in plane view.

### [Covering Step]

In the seventh embodiment, the covering step shown in FIG. 10 (b) is performed instead of the embedding step in the sheet disposing step shown in FIG. 7 (b). The conditions of the covering step are the same as those of the embedding step.

In the covering step shown in FIG. 10 (b), each of the cover portions 43 covers the upper surface of each of the LEDs 4. The LED 4 is pressed into the cover portion 43 by pressing of the LED 4, so that the cover portion 43 slightly expands outwardly in the plane direction. The degree of expansion thereof is subtle, so that in FIG. 10 (b), the lengths in the right-left direction of the cover portion 43 and the LED 4 after the pressing are shown to be the same.

### [Curing Step]

In the seventh embodiment, the curing step shown in FIG. 10 (c) is performed instead of the encapsulating step shown in FIG. 7 (c).

In the curing step, the cover portions 43 are cured. The conditions of the curing step are the same as those of the above-described encapsulating step.

In the seventh embodiment, the same function and effect as that of the fifth embodiment can be achieved.

### <Eighth Embodiment>

FIG. 11 shows process drawings for illustrating an eighth embodiment of a method for producing a phosphor layer-covered LED of the present invention.

In the eighth embodiment, the same reference numerals are provided for members and steps corresponding to each of those in the first embodiment, and their detailed description is omitted.

In the first embodiment, as shown in FIG. 1 (b), in the sheet disposing step, the embedding step in which the side surfaces and the upper surfaces of the LEDs 4 are covered with the phosphor sheet 5 is performed. Alternatively, for example, as shown in FIG. 11 (b), the covering step in which the side surfaces only of the LEDs 4 are covered with the phosphor sheet 5 can be performed instead of the embedding step. Also, the curing step can be performed instead of the encapsulating step.

### [Sheet Disposing Step]

As shown in FIG. 11 (b), the thickness of the prepared phosphor sheet 5 is set to be thinner than that of each of the LEDs 4, that is, set to be, for example, 95 % or less, or preferably 90 % or less, and to be, for example, 10 % or more with respect to the thickness of each of the LEDs 4. To be specific, the thickness of the phosphor sheet 5 is set to be, for example, 1000 µm or less, or preferably 800 µm or less, and to be, for example, 30 µm or more, or preferably 50 µm or more.

As shown in FIG. 11 (b), in the covering step, a laminate (ref: the upper side view in FIG. 11 (a)) made of the release sheet 13 and the phosphor sheet 5 laminated on the lower surface of the release sheet 13 is pressed into the support sheet 12 including the LEDs 4 so that the lower surface of the release sheet 13 is in contact with the upper surfaces of the LEDs 4 by the pressing.

The upper surface of the phosphor sheet 5, which is pressed into gaps between a plurality of the LEDs 4, is formed to be flush with the upper surfaces of the LEDs 4. The lower surface of the phosphor sheet 5 is also formed to be flush with the lower surfaces of the LEDs 4. That is, the thickness of the phosphor sheet 5, which is pressed into gaps between a plurality of the LEDs 4, is pressed is the same as that of each of the LEDs 4.

The side surfaces of the LED 4 are covered with the phosphor sheet 5, while both a bump that forms a portion of the lower surface of the LED 4 and the upper surface of the LED 4 are exposed from the phosphor sheet 5.

### [Curing Step]

In the curing step, as shown in FIG. 11 (c), the phosphor sheet 5 is cured. The conditions of the curing step are the same as those of the above-described encapsulating step.

### [Cutting Step]

As shown by the dashed lines in FIG. 11 (d), the phosphor sheet 5 is cut, while the position of the LEDs 4 is checked from the upper side. To be specific, in the phosphor sheet 5, the position of the LEDs 4 is checked, while the LEDs 4 are visually confirmed from the upper side with, for example, a camera. As referred in the dashed lines in FIG. 3, the phosphor sheet 5 is cut so that the cuts 8 that define a region surrounding each of the LEDs 4 are formed in plane view.

The phosphor sheet 5 can be also cut, while the LEDs 4 are visually confirmed, in addition, with reference marks 18 (ref: FIG. 3) as a reference.

### [LED Peeling Step]

In FIG. 11 (e), in the LED peeling step, each of the phosphor sheet-covered LEDs 10 is peeled from the upper surface of the support sheet 12. That is, each of the phosphor sheet-covered LEDs 10 is peeled from the support sheet 12 so that interfacial peeling occurs between the phosphor sheet 5 and the LEDs 4, and the support sheet 12.

In the eighth embodiment, the same function and effect as that of the first embodiment can be achieved.

In addition, in the covering step, the side surfaces of the LEDs 4 are covered with the phosphor sheet 5 so that at least the upper surfaces of the LEDs 4 are exposed from the phosphor sheet 5. Thus, in the cutting step after the sheet disposing step, the LEDs 4 having the upper surfaces exposed are visually confirmed and the phosphor sheet 5 can be accurately cut corresponding to the LEDs 4. Therefore, the phosphor sheet-covered LED 10 to be obtained has excellent size stability. As a result, the LED device 15 including the phosphor sheet-covered LED 10 has excellent luminous stability.

### <Ninth Embodiment>

FIG. 12 shows a perspective view of a dispenser used in a ninth embodiment of a method for producing a phosphor layer-covered LED of the present invention.

In the ninth embodiment, the same reference numerals are provided for members and steps corresponding to each of those in the first embodiment, and their detailed description is omitted.

In the first embodiment, as shown in FIG. 1 (b), in the sheet disposing step that is one example of the layer disposing step of the present invention, the phosphor sheet 5 that is formed in advance is illustrated as one example of the phosphor layer of the present invention. Alternatively, as referred in FIG. 12, for example, a phosphor resin composition is prepared as a varnish and the varnish is directly applied onto the support sheet 1 so as to cover a plurality of the LEDs 4, so that a phosphor layer 25 can be also formed. That is, the phosphor layer 25 can be formed from the varnish of the phosphor resin composition.

In order to form the phosphor layer 25, first, the varnish is applied onto the support sheet 1 so as to cover the LEDs 4.

In order to apply the varnish, for example, an application device such as a dispenser, an applicator, or a slit die coater is used. Preferably, a dispenser 26 shown in FIG. 12 is used.

As shown in FIG. 12, the dispenser 26 integrally includes an introduction portion 27 and an application portion 28.

The introduction portion 27 is formed into a generally cylindrical shape extending in the up-down direction and the lower end portion thereof is connected to the application portion 28.

The application portion 28 is formed into a flat plate shape extending in the right-left and the up-down directions. The application portion 28 is formed into a generally rectangular shape in side view that is long in the up-down direction. The introduction portion 27 is connected to the upper end portion of the application portion 28. The lower end portion of the application portion 28 is formed into a tapered shape in sectional side view in which the front end portion and the rear end portion are cut off. The lower end surface of the application portion 28 is configured to be capable of being pressed with respect to the upper surface of a pressure-sensitive adhesive layer 3 and the upper surfaces of the LEDs 4. Furthermore, at the inside of the application portion 28, a broad flow path (not shown) in which a varnish introduced from the introduction portion 27 gradually expands in the right-left direction as it goes toward the lower section (downwardly) is provided.

The dispenser 26 is configured to be movable relatively in the front-rear direction with respect to the support sheet 1 extending in the plane direction.

In order to apply the varnish to the support sheet 1 using the dispenser 26, the application portion 28 is disposed in opposed relation (pressed) to the upper surfaces of a plurality of the LEDs 4 and the varnish is supplied to the introduction portion 27. Along with this, the dispenser 26 is moved relatively toward the rear side with respect to a plurality of the LEDs 4. In this way, the varnish is introduced from the introduction portion 27 into the application portion 28 and subsequently, is broadly supplied from the lower end portion of the application portion 28 to the support sheet 1 and the LEDs 4. By the relative movement of the dispenser 26 toward the rear side with respect to a plurality of the LEDs 4, the varnish is applied onto the upper surface of the support sheet 1 in a belt shape extending in the front-rear direction so as to cover a plurality of the LEDs 4.

The varnish is prepared from the phosphor resin composition in an A-stage state. When the varnish is, for example, supplied from the application portion 28 to the support sheet 1, it does not flow out of its position outwardly in the plane direction. That is, the varnish has viscous properties of keeping its position. To be specific, the viscosity of the varnish under conditions of 25°C and 1 pressure is, for example, 1,000 mPa·s or more, or preferably 4,000 mPa·s or more, and is, for example, 1,000,000 mPa·s or less, or preferably 100,000 mPa·s or less. The viscosity is measured by adjusting a temperature of the varnish to 25°C and using an E-type cone at a number of revolutions of 99 s⁻¹.

When the viscosity of the varnish is not less than the above-described lower limit, the varnish can be effectively prevented from flowing outwardly in the plane direction. Thus, it is not required to separately provide a dam member or the like in the support sheet 1 (to be specific, around a plurality of the LEDs 4), so that a simplified process can be achieved. Then, the varnish can be easily and surely applied to the support sheet 1 with a desired thickness and a desired shape with the dispenser 26.

On the other hand, when the viscosity of the varnish is not more than the above-described upper limit, the application properties (the handling ability) can be improved.

Thereafter, the varnish that is applied from the phosphor resin composition by application of an active energy ray is brought into a B-stage state (a semi-cured state).

In this way, the phosphor layer 25 in a B-stage state is formed on the support sheet 1 (on the upper surface of the pressure-sensitive adhesive layer 3) so as to cover a plurality of the LEDs 4.

In the ninth embodiment, the same function and effect as that of the first embodiment can be achieved.

### <Modified Example>

In the first to ninth embodiments, a plurality of the LEDs 4 are covered with the phosphor sheet 5. Alternatively, for example, a single piece of the LED 4 can be covered with the phosphor sheet 5.

In such a case, to be specific, in the cutting step shown in FIG. 1 (d) that is illustrated in the first embodiment, the phosphor sheet 5 around the LED 4 is trimmed (subjected to trimming) so as to have a desired size.

### [Examples]

While the present invention will be described hereinafter in further detail with reference to Examples, the present invention is not limited to these Examples.

### Example 1

<LED Disposing Step>

First, a support sheet having a size of 50 mm × 50 mm × 0.1 mm in a rectangular shape in plane view and made of ELEP HOLDER (a dicing tape, an ultraviolet irradiation release sheet, manufactured by NITTO DENKO CORPORATION) was prepared (ref: FIG. 1 (a)). The support sheet was also a stretchable sheet and had a tensile elasticity at 23°C of 500 MPa.

Next, a plurality of LEDs (blue light emitting elements), each of which had a size of 1 mm × 1 mm × 0.3 mm in a rectangular shape in plane view, were disposed on the upper surface of the support sheet (ref: FIG. 1 (a)). The gap between the LEDs was 0.3 mm.

### <Sheet Disposing Step>

### [Preparation of First Silicone Resin Composition]

After 100 g (8.70 mmol) of a silicone oil containing silanol groups at both ends (a polydimethylsiloxane containing silanol groups at both ends, manufactured by Shin-Etsu Chemical Co., Ltd., a number average molecular weight of 11500); 0.43 g [2.9 mmol, the molar ratio (hydroxyl group/methoxy group) of the hydroxyl group in the silicone oil containing silanol groups at both ends to the methoxy group in the vinyltrimethoxysilane = 2/1] of a vinyltrimethoxysilane (manufactured by Shin-Etsu Chemical Co., Ltd.); and 0.58 g [4.3 mmol, the molar ratio (hydroxyl group/methoxy group) of the hydroxyl group in the silicone oil containing silanol groups at both ends to the methoxy group in the vinyldimethoxymethylsilane = 2/1] of a vinyldimethoxymethylsilane (manufactured by Tokyo Chemical Industry Co., Ltd.) were stirred and mixed, 0.074 g (0.17 mmol, 2.0 mol % with respect to 100 mol of the silicone oil containing silanol groups at both ends) of di(2-ethylhexanoate) tin (II) (a concentration of 95 mass %) as a condensation catalyst was added thereto to be stirred at 70°C for two hours. In this way, a first polysiloxane in an oil state was prepared.

After the first polysiloxane was cooled to room temperature, 2.4 g [the molar ratio (vinyl group/hydrosilyl group) of the vinyl group in the vinyltrimethoxysilane to the hydrosilyl group in the organohydrogenpolysiloxane = 1/3] of an organohydrogenpolysiloxane (a polydimethylsiloxane containing hydrosilyl groups at both ends, manufactured by Shin-Etsu Chemical Co., Ltd) as a second polysiloxane and 0.075 mL (15 ppm to the total of the first silicone resin composition) of a solution of trimethyl (methylcyclopentadienyl) platinum (IV) (a platinum concentration of 2 mass %) as an addition catalyst (a hydrosilylation catalyst) were added to the first polysiloxane, so that a transparent first silicone resin composition in an oil state and in an A-stage state was obtained.

### [Fabrication of Phosphor Sheet]

15 g of a phosphor made of YAG was mixed and stirred with respect to 100 g of the first silicone resin composition in an A-stage state, so that a phosphor dispersion was prepared. The obtained phosphor dispersion was applied to the surface of a release sheet made of PET to be then heated at 135°C for 3 minutes, so that the first silicone resin composition was brought into a B-stage state (a semi-cured state, gelated). In this way, a phosphor sheet made of a silicone semi-cured material and containing a phosphor with a thickness of 450 µm was fabricated (ref: the upper portion in FIG. 1 (a)).

### [Compressive Bonding of Phosphor Sheet]

Thereafter, the fabricated phosphor sheet was disposed on the upper surface of the support sheet so as to embed a plurality of the LEDs. To be specific, as shown by the arrows in FIG. 1 (a), and in FIG. 1 (b), the phosphor sheet laminated on the release sheet was compressively bonded toward the support sheet on which the LEDs were disposed (ref: FIG. 1 (b)).

Subsequently, the release sheet was peeled from the support sheet (ref: the phantom lines in FIG. 1 (b)).

### <Encapsulating Step>

Thereafter, an ultraviolet ray was applied from the upper side to the phosphor sheet at the amount of irradiation of 3 J/cm² for 1 minute (ref: FIG. 1 (c)). In this way, the silicone semi-cured material was brought into a C-stage state and the phosphor sheet was completely cured (ref: FIG. 1 (c)).

In this way, the LEDs were encapsulated by the phosphor sheet in a C-stage state.

### <Cutting Step>

Subsequently, the phosphor sheet was cut (subjected to dicing) with a dicing device provided with a disc-shaped dicing blade. In this way, phosphor layer-covered LEDs, each of which included the LED and the phosphor layer covering the LED with a size of 1.4 mm × 1.4 mm × 0.5 mm, were obtained (ref: FIG. 1 (d)).

### <LED Peeling Step>

Thereafter, the support sheet was stretched in the plane direction and each of the phosphor layer-covered LEDs was peeled from the support sheet (ref: FIG. 1 (e)). To be specific, first, the support sheet was stretched outwardly in the plane direction. Subsequently, each of the phosphor layer-covered LEDs was peeled from the support sheet using a pick-up device provided with a collet and a needle (ref. FIG. 1 (e')).

### <Mounting Step>

Thereafter, after the phosphor layer-covered LED was selected in accordance with emission wavelength and luminous efficiency, the selected phosphor layer-covered LED was flip-chip mounted on a board (ref: FIG. 1 (f)). To be specific, a bump in the phosphor layer-covered LED was connected to a terminal provided on the upper surface of the board.

## Claims

1. A method for producing a phosphor layer-covered LED (10) comprising:
an LED disposing step of disposing an LED (4) at one surface in a thickness direction of a support sheet (12);
a layer disposing step of disposing a phosphor layer (5) formed from a phosphor resin composition containing an active energy ray curable resin capable of being cured by application of an active energy ray and a phosphor at the one surface in the thickness direction of the support sheet (1) so as to cover the LED;
a curing step of applying an active energy ray to the phosphor layer (5) to be cured;
a cutting step of cutting the phosphor layer (5) corresponding to the LED (4) to produce a phosphor layer-covered LED (10) including the LED and the phosphor layer covering the LED; and
an LED peeling step of, after the cutting step, peeling the phosphor layer-covered LED (10) from the support sheet (1).

2. The method for producing a phosphor layer-covered LED (10) according to claim 1, wherein
the phosphor layer is formed of a phosphor sheet (5).

3. The method for producing a phosphor layer-covered LED (10) according to claim 1 or 2, wherein
the support sheet (12) is capable of stretching in a direction perpendicular to the thickness direction and
in the LED peeling step, the phosphor layer-covered LED (10) is peeled from the support sheet (10), while the support sheet (12) is stretched in the direction perpendicular to the thickness direction.

4. The method for producing a phosphor layer-covered LED (10) according to claim 1, 2 or 3, wherein
the support sheet (12) is a thermal release sheet in which the pressure-sensitive adhesive force is capable of being reduced by heating and
in the LED peeling step, the support sheet (12) is heated and the phosphor layer-covered LED (10) is peeled from the support sheet.

5. The method for producing a phosphor layer-covered LED (10) according to any of claims 1 to 4, wherein
the phosphor layer includes a cover portion (33, 43) that covers the LED and
a reflector portion (34) that contains a light reflecting component and is formed so as to surround the cover portion (33, 43).

6. A phosphor layer-covered LED (10) obtained by a method for producing a phosphor layer-covered LED according to any of claims 1 to 5.

7. An LED device comprising:
a board (9) and
a phosphor layer-covered LED (10) mounted on the board, wherein
the phosphor layer-covered LED (10) is obtained by a method for producing a phosphor layer-covered LED according to any of claims 1 to 5.
